# EUROPEAN PATENT APPLICATION

(11) **EP 1 030 351 A1**
(43) Date of publication of application: **23.08.2000**
(21) Application number: 98953012.6
(22) Date of filing: 11.11.1998
(51) Int. Cl.: H01L 21/027, G03F 7/20

(54) **EXPOSURE APPARATUS, APPARATUS FOR MANUFACTURING DEVICES, AND METHOD OF MANUFACTURING EXPOSURE APPARATUSES**

(30) Priority: 12.11.1997 JP 31043997; 27.11.1997 JP 32636397; 25.12.1997 JP 35668097
(71) Applicant: Nikon Corporation, Tokyo 100-8331 (JP)
(72) Inventor: MAGOME, Nobutaka Nikon Corporation, Tokyo 100-8331 (JP); NISHIKAWA, Jin Nikon Corporation, Tokyo 100-8331 (JP)
(74) Representative: Gill, David Alan
(86) International application number: JP9805073
(87) International publication number: WO9925010

(57) **Abstract**

An exposure apparatus having an illumination system which applies an exposure energy beam to a mask on which a pattern for transfer is formed, and a stage system for positioning a substrate to which the pattern of the mask is transferred, is characterized in that: a gas supply apparatus for supplying a gas of a high transmittivity with respect to the exposure energy beam, and having good thermal conductivity, to at least a portion of an optical path of the exposure energy beam, and a gas recovery apparatus for recovering at least a portion of the gas after the gas is supplied to the optical path of the exposure energy beam from the gas supply apparatus, are provided.

## Description

### Technological Field

The present invention relates to an exposure apparatus, an apparatus for manufacturing devices, and a method of manufacturing exposure apparatuses, which are employed in transferring a mask pattern onto a substrate in a lithography process for producing microdevices such as, for example, semiconductor elements, liquid crystal display elements, image pickup elements, or thin film magnetic heads or the like, and are preferably employed when exposure light in the ultraviolet band having a wavelength of approximately 400 nm or less, and particularly when exposure light of the vacuum ultraviolet (VUV) band having a wavelength of 200 nm or less, is employed.

### Background Art

In exposure apparatuses such as steppers or the like which are employed, for example, in the manufacture of semiconductor devices, in order to provide an increase in the degree of integration or minuteness of the semiconductor devices, an increase in resolution is particularly necessary. This resolution is essentially proportional to the wavelength of the exposure light, so that conventionally the wavelengths of the exposure light were progressively shortened. That is to say, the exposure light employed changed from the g line in the visible band of mercury lamps (wavelength 436 nm) to the i line in the ultraviolet band (wavelength 365 nm), and recently, KrF excimer laser light (wavelength 248 nm) has come to be employed. Additionally, presently, ArF excimer laser light (wavelength 193 nm), F₂ laser light (wavelength 157 nm) and Ar₂ laser light (wavelength 126 nm) are being considered for use. Furthermore, in conventional X-ray lithography research, the use of light having wavelengths of 13 nm, 11 nm, or 7 nm, which are in the so-called extreme ultraviolet (EUV or XUV) band and are close to X-rays, and the use of X-rays having a wavelength of approximately 1 nm, has been considered.

However, when wavelength bands of less than approximately that of ArF excimer lasers, that is to say, the vacuum ultraviolet band (VUV) of approximately 200 nm or less, are employed, absorption occurs as a result of the oxygen in the air, and ozone is produced, and transmittivity declines. In exposure apparatuses which employ ArF excimer laser light, for example, the majority of the gas in the optical path of the exposure light is replaced by nitrogen, so that the so-called nitrogen purge is conducted. Furthermore, at wavelength bands of less than approximately that of the F₂ laser, absorption occurs even with nitrogen. In this case, if the region of nitrogen passage is an extremely narrow region, the amount of absorption is slight, and no obstacle is presented to exposure; however, with a long optical path, the amount of light is reduced, and proper amounts of exposure can not be obtained. When light in a wavelength band shorter than the wavelength of the ArF excimer laser (less than approximately 190 nm) and particularly when light in the wavelength band of less than approximately the wavelength of the F₂ laser, is employed, then it is necessary either to replace the majority of gas of the optical path of the light with another gas which allows transmission of light (an inert gas other than nitrogen), or to provide a vacuum.

On the other hand, when the exposure light passes an illumination optical system or optical elements, such as lenses and mirrors, within a projection optical system, then there is absorption of the heat energy by these optical elements as well. When the optical elements experience thermal expansion as a result of the heat energy absorbed in this way, this leads to degradation in image formation characteristic, such as changes in magnification, focal shift displacement, or the like. In order to prevent this degradation in image formation characteristic, conventionally, waste heat treatment was conducted, in which temperature controlling gases were caused to flow in predetermined spaces between lenses, and the side surfaces of lenses or the rear surfaces of mirrors or the like were subjected to air cooling or liquid cooling. Recently, requirements have also increased with respect to stability of the image formation characteristic, so that an even higher level of treatment is required with respect to this waste heat treatment as well.

As described above, in exposure apparatuses, when exposure light in a wavelength band of approximately 190 nm or less is employed, it is desirable that the gas of the majority of the optical path be replaced with a gas having an absorption ratio smaller than nitrogen, or that this be made a vacuum. However, when the latter is done and the majority of the optical path is made into a vacuum, the manufacturing costs of the exposure apparatus increase, and the throughput of the exposure apparatus declines. Furthermore, in the exposure apparatus, it is desired that the heat energy of the exposure light be more efficiently exhausted.

In order to simultaneously address these problems, a gas may be supplied to the majority of the optical path of the exposure light, which gas is inert and has a high transmittivity and has good thermal conductivity (in other words, has a low atomic weight), and which is temperature controlled. Currently, the most highly functional gas for use as this type of inert gas having good thermal conductivity, and which is moreover stable, is helium (He). However, helium is present in the earth's crust and in the atmosphere at an extremely low rate, and is high in cost, so that as the amount thereof used increases, the operational cost of the exposure apparatus rise greatly, and this is undesirable. Furthermore, because helium has a low atomic weight, it tends to leak from the gaps in the cover and the like which enclose the optical path of the exposure apparatus, and this presents a problem in that if helium is simply circulated within the cover, the amount of helium progressively decreases.

In view of these points, the present invention has as an object thereof to provide an exposure apparatus and a apparatus for manufacturing devices which, in the case in which a gas having a high transmittivity (inert) and having good thermal conductivity is supplied to at least a portion of an optical path of an exposure energy beam (exposure light), are capable of controlling the amount of this gas which is employed.

Furthermore, as described above, in the exposure apparatus, when exposure light having a wavelength of approximately 200 nm or less is employed, if the optical path of the exposure light is not made into a vacuum, it is necessary to replace the majority of the optical path of the exposure light with a gas having good transmittivity (such as nitrogen or the like). Furthermore, even where the wavelength is within a range of 250 - 200 nm, in order to obtain good transmittivity, it is desirable that the optical path of the exposure light be replaced with nitrogen or the like.

In connection with this, because the exposure apparatus is usually stored within a box shaped chamber having good airtightness and in order to conduct the positioning of reticles or wafers or the like in a highly precise manner in the exposure apparatus, a stage system, in which movement is conducted along a guide surface in the manner of an air bearing without contact, is provided. For this reason, when this type of stage system is employed, the compressed air sprayed along the guide surface leaks out into the chamber, and this air mixes with the gas having good transmittivity, such as nitrogen or the like, of the optical path of the exposure light, so that a problem is caused in that the transmittivity with respect to the exposure light progressively decreases. When the transmittivity decreases in this manner, the illumination intensity on the wafer decreases, so that in order to obtain the proper amount of exposure, it is necessary to lengthen the exposure period, and thus the throughput of the exposure process declines in an undesirable manner.

Furthermore, in the exposure apparatus, in addition to the stage system, equipment is provided for conducting positioning or vibration isolation or the like using air; there is also a danger that this air generated by this equipment will cause a decrease in the transmittivity of the exposure light.

In view of these points, the present invention has as an object thereof to provide an exposure apparatus which, in the case in which a predetermined gas having a high transmittivity is supplied to at least a portion of the optical path of an exposure energy beam (exposure light), is capable of guiding this exposure energy beam to the substrate which is the object of exposure such as a wafer or the like with a high use efficiency.

Furthermore, when conducting various exposure experiments by means of a projection exposure apparatus having a comparatively large field size using an excimer laser light source, the present inventors discovered a novel phenomenon, in which, by means of the application of illumination light in an ultraviolet wavelength band of, for example, 350 nm or less (a KrF exposure excimer laser having a wavelength of 248 nm, or a ArF excimer laser having a wavelength of 193 nm, or the like), the transmittivity or reflectivity of the optical elements or coating materials of the optical elements (for example, thin films such as reflection prevention films or the like) within the projection optical system varied dynamically. It has been made clear that this phenomenon of the dynamic fluctuation of transmittivity can be generated not merely with respect to the optical elements within the projection optical system, but also with respect to the optical elements or reticles (silica plates) themselves within the illumination optical system which illuminates the reticle or within the light transmission system which conveys the illumination light emitted from a light source positioned beneath the floor of the clean room to the illumination optical system within the exposure apparatus itself. In the present specification the term illumination optical system includes the light transmission system.

Such a phenomenon is thought to be produced when impurities contained within the gas (air, nitrogen gas, or the like) present in spaces within the projection optical path or the illumination optical path, molecules of organic matter generated by filler material or adhesives used to affix the optical elements to the barrel, or impurities (for example, water molecules, hydrocarbon molecules, or other substances which scatter the illumination light) generated from the inner wall of the barrel (the coated surface for preventing reflection or the like), are deposited on the surface of the optical elements, or enter into the illumination optical path (float). As a result, a serious problem is caused in that the transmittivity or reflectivity of the projection optical system or illumination optical system can vary greatly within a comparatively short period of time.

It is an object of the present invention to provide a projection exposure apparatus which supports optical elements such as lenses or reflection mirrors or the like which comprise the projection optical system or illumination optical system without the use of adhesives or fillers.

### DISCLOSURE OF THE INVENTION

The exposure apparatus in accordance with the present invention is, in an exposure apparatus having an illumination system (3, 11, 13, 14, 17-19) for applying an exposure energy beam to a mask forming a pattern for transfer, and a stage system (20-24) which positions a substrate to which the mask pattern is to be transferred, a gas supply apparatus (31, 43, 46) which supplies a gas having a high transmittivity with respect to the exposure energy beam and having good thermal conductivity to at least a portion of the optical path of the exposure energy beam, and a gas recovery apparatus (33 - 37, 41,42) which recovers at least a portion of the gas dispersed after being supplied to the optical path of the exposure energy beam from the gas supply apparatus, are provided.

In accordance with this present invention, because it is possible to recover and reuse (recycle) a portion of the gas supplied to the optical path, it is possible to control the amount of this gas employed. Accordingly, the operational costs decrease when the gas is high in cost.

In this case, an example of the gas is helium (He). Helium is safe and has a high transmittivity even when exposure light of the wavelength band of 150 nm or less is employed, and because the thermal conductivity thereof is high, being approximately 6 times that of nitrogen (N₂), the cooling effect with respect to the optical element is high.

Furthermore, where the gas recovery apparatus recovers, for example, helium dispersed in the air, it is possible to separate the helium by processing the oxygen present in the mixed gas using an oxygen adsorbing material, and cooling the nitrogen, so that the remaining helium may be recovered. Alternatively, by cooling the mixed gas to the temperature of liquid air, and removing the liquid which is generated, it is easily possible to recover only the helium which remains in a gaseous state.

Furthermore, it is desirable that the gas recovery apparatus be employed in common with a plurality of exposure apparatuses. By means of this, the equipment costs of the gas recovery apparatus are reduced.

Furthermore, it is desirable that the gas recovered by the gas recovery apparatus be recirculated to the optical path of the exposure energy beam via at least a portion (31, 43) of the gas supply apparatus.

Furthermore, the gas supply apparatus has, as one example, a concentration meter (44) for measuring the density of the gas supplied from the gas recovery system, a gas source (46) with the gas sealed therein in a gaseous state or in a liquid state, and control units (43,45, 48) which supplement the gas supplied from the gas recovery apparatus with gas from the gas source (46) in accordance with the results of the measurement of the concentration meter. These control units supply gas from the gas source when the density of the gas measured by the concentration meter becomes lower than a predetermined allowable level. By means of this, the gas within the gas source is not used wastefully.

Furthermore, this gas supply apparatus is provided with, as an alternative example, a gas source (46) which conducts the liquid storage or high pressure storage of gas, a conversion apparatus which returns the liquid gas or high pressure gas within the gas source to a gaseous state, and an adjusting apparatus (43) which regulates the temperature and pressure of the gas from the gas source prior to its supply to the exposure apparatus. By means of this it is possible to store a large amount of the gas in a small space.

Furthermore, it is desirable that the gas recovery apparatus store the recovered gas in a liquefied or high pressure form. By means of this, it is possible to store a large amount of the gas in a small space.

Furthermore, the device manufacturing apparatus in accordance with the present invention is provided with a plurality of exposure apparatuses, including exposure apparatuses in accordance with the present invention, and using this plurality of exposure apparatuses, transfers a plurality of device patterns onto a substrate which is the object of exposure in an overlapping manner, producing microdevices. In this case, as well, the amount of gas employed can be controlled.

The exposure apparatus in accordance with the present invention is an exposure apparatus which illuminates a mask (R) with a predetermined energy beam, and transfers the pattern formed in this mask to a substrate (W), wherein a gas-controlled drive apparatus (123, 125A) which conducts predetermined operations (positioning, vibration isolation, and the like) using a first gas for control is provided, and a second gas having good transmittivity is supplied to at least a portion of the optical path of the exposure energy beam, and a gas of the same type as the second gas is employed as the first gas of the gas-controlled drive apparatus.

In accordance with this invention, the gas which is exhausted when the gas-controlled drive apparatus is driven is a gas of the same type as the second gas having good transmittivity with respect to the exposure energy beam, so that the concentration of the second gas supplied to the optical path of the exposure energy beam progressively decreases. Accordingly, the progressive decrease in the transmittivity with respect to the exposure energy beam is eliminated, and it is possible to guide the exposure energy beam to the substrate with a high efficiency of use.

In this case, an example of this gas-controlled drive apparatus is a stage apparatus (123) which makes contact with the guide surface in the form of a gas bearing system, a gas type cylinder apparatus, or a vibration isolation platform (125A) employing gas as a portion of the shock absorbing material. The exposure apparatus is normally contained within a box shaped chamber so that when a gas of a type other than the second gas is emitted from the gas-controlled drive apparatus the transmittivity of the exposure energy beam within the chamber progressively decreases; however, in accordance with the present invention a decrease in the transmittivity of the exposure energy beam within the chamber is prevented.

Furthermore, when the exposure energy beam is ultraviolet light having a wavelength of 250 nm or less, then it is desirable that the second gas be nitrogen (N₂) or helium (He). In particular, since the transmittivity of nitrogen is good when the wavelength is from 250 to 200 nm, it is possible to employ low cost nitrogen. Furthermore, these gases are inert, so that fogging materials or the like will not be generated on the surface of the optical elements.

Furthermore, when the exposure energy beam is ultraviolet light having a wavelength of 200 nm or less, it is desirable that the second gas be helium. Helium has high transmittivity with respect to light of such short wavelengths, and additionally has particularly good thermal conductivity, so that its ability to cool the optical elements and the like is high. Furthermore, when, as an example of the wavelength of 200 nm or less, ArF excimer laser light having a wavelength of 193 nm is employed as the exposure energy beam, and a projection optical system comprising a cata-dioptric system is employed, the cata-dioptric system has fewer lenses than a refractive system, and the distance between lenses is greater, so that it is more susceptible to effects of fluctuations in atmospheric pressure. By purging the interior of the projection optical system comprising a cata-dioptric system with helium, which has a considerably smaller degree of change in the index of refraction in response to changes in air pressure, in comparison with nitrogen, it is possible to control the amount of fluctuation in the image forming characteristics at a low level.

Furthermore, when the exposure energy beam is an X-ray (for example, a wavelength within a range of approximately 10 nm - 1 nm) then examples of the second gas are nitrogen or helium. Even when X-rays are employed, if the distances are short, the amount of attenuation can be kept at a low level.

The exposure apparatus (projection exposure apparatus) of the present invention is provided with an illumination optical system which applies illumination light from an illumination light source to a mask and which has a plurality of optical elements (9A, 9B, 11...(109A, 109B, 111...)) which are supported by support members, and with a projection optical system (PL) which projects the image of a pattern on a mask (original plate) onto an exposed substrate, which system is provided with a plurality of optical elements (L201, L202...) which are supported by support members. Additionally, all the optical elements described above are supported on the support members using press-attachment mechanisms without employing adhesive, and thereby, the objects described above are obtained.

Furthermore, an example of this press-attachment mechanism is a flat spring (261), one end of which is affixed to the inner circumferencial part of the support member (251), and the other end of which presses against the outer circumferencial part of the optical element (L201, L202) at the other end.

Furthermore, another example of this press-attachment mechanism is one in which screwable attachment is conducted to a screw part attached to the inner circumferencial part of the support member (252), and a screw ring (263) is screwably advanced and presses the outer circumferencial part of the optical elements (L203 -L205).

Furthermore, an exposure apparatus (projection exposure apparatus) in accordance with the present invention is provided with an illumination optical system (232) which has a plurality of optical elements (204, 205, 206...) containing fly eye lenses (11, 111) which bundle a plurality of rod lenses (L260) and which applies illumination light from an illumination light source (201) to a mask, as well as with a projection optical system which is provided with a plurality of optical elements (L201, L202,...) which are supported by support members and which projects the image of a pattern on a mask (original plate) onto an exposure substrate. Then, by bundling a plurality of rod lenses (L260) using a support apparatus (280) without the use of an adhesive, the objects described above are achieved.

Furthermore, in a manufacturing method for exposure apparatuses in accordance with the present invention, a supply pipe for supplying a gas which reduces attenuation in the exposure energy beam is connected to a gas chamber which seals, in an essentially airtight manner, at least a portion of the optical path of the exposure energy beam, and a recovery pipe which recovers at least a portion of the gas supplied to the gas chamber is connected to at least one of the gas chamber and a housing in which the gas chamber is disposed. Then, the recovery pipe is connected to a removal apparatus which removes impurities from the recovered gas, and the removal apparatus and the supply pipe are connected. Furthermore, the optical elements which the exposure energy beam passes are assembled in the exposure apparatus by being fixed to support members without the use of adhesive. Furthermore, a gas control type drive apparatus which employs a gas having optical characteristics which are essentially the same as those of the gas which is disposed in the exposure apparatus, and a supply source for this gas, are connected.

In accordance with this invention, a portion of the gas supplied to the optical path may be recovered and reused (recycled) so that it is possible to control the amount of this gas which is employed, and it is thus possible to construct an exposure apparatus which makes possible a reduction of operational costs.

In this section disclosing the invention which explains the structure of the present invention, diagrams of the embodiments of the invention are employed in order to facilitate understanding of the present invention; however, the present invention is not limited to these embodiments of the invention.

### BRIEF DESCRIPTION OF THE DIAGRAMS

Figure 1 is a schematic structural view of a projection exposure apparatus in accordance with a first mode of the present invention, wherein a portion has been removed, which shows a portion of the helium circulation apparatus and a portion of the nitrogen circulation apparatus.
Figure 2 is a schematic structural view in which a portion has been removed, showing the main parts of the helium circulation apparatus and the nitrogen circulation apparatus in this embodiment.
Figure 3 is a schematic structural diagram in which a portion has been rendered in cross sectional view, showing a plurality of projection exposure apparatuses and a single helium recovery apparatus in a second embodiment of the present invention.
Figure 4 is a schematic structural view in which a portion has been rendered in cross sectional view, showing a modification of the projection exposure apparatus of the first embodiment of the present invention.
Figure 5 is a schematic structural view in which a portion has been rendered in cross section, showing the projection exposure apparatuses and helium supply apparatus of an example of the third embodiment of the present invention.
Figure 6 is a cross sectional view of the main parts of the wafer stage in Figure 5 as viewed from the X direction.
Figure 7 shows the concept in the case in which the lenses of the projection optical system are supported by flat springs.
Figure 8 is a detailed view of the press-attachment mechanism employing flat springs.
Figure 9 is a perspective view showing the details of the fly eye lens.
Figure 10A is a top view of the fly eye lens, while Figure 10B is a front view thereof, and Figure 10C is a side view thereof.

### EMBODIMENTS

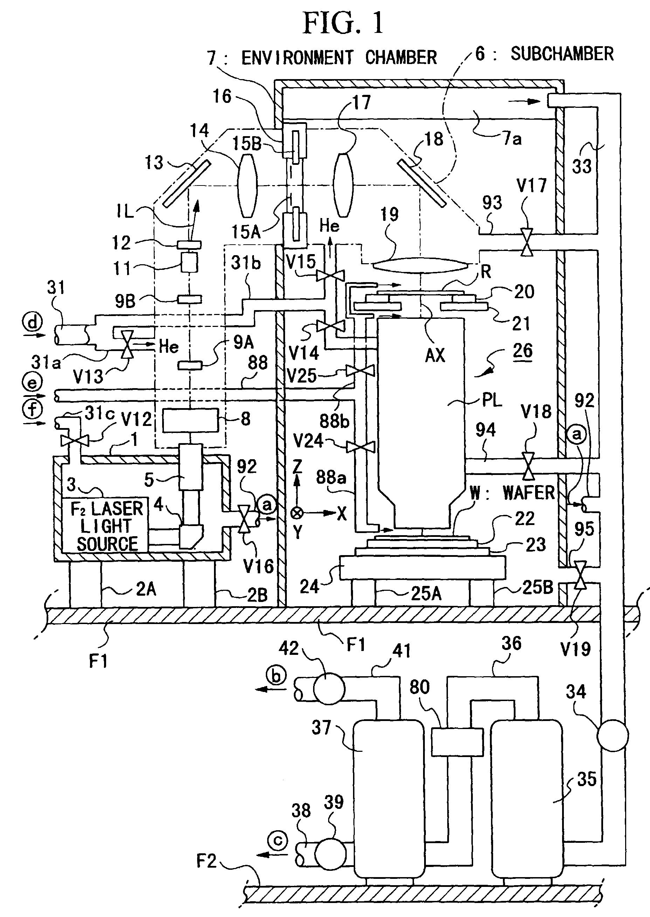

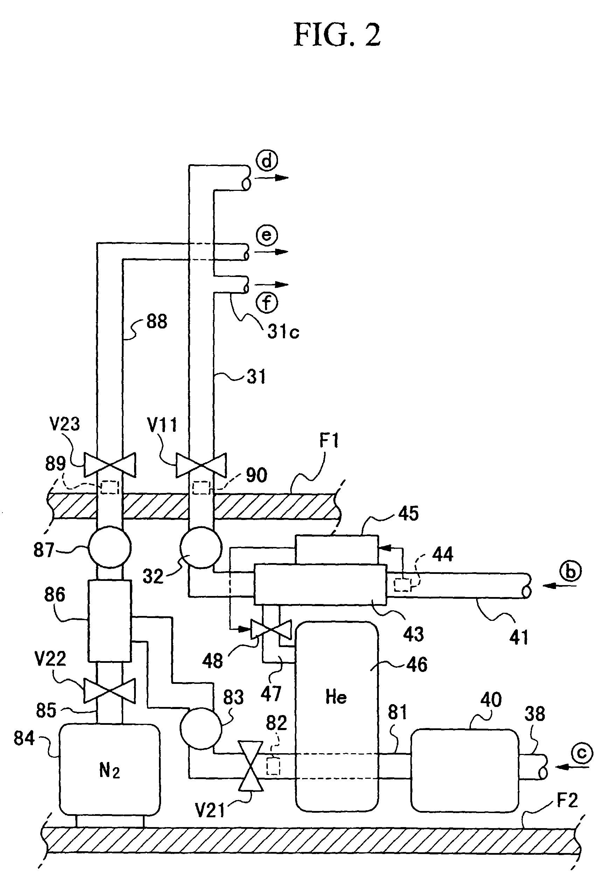

Hereinbelow, a first embodiment of the present invention will explained with reference to Figures 1 and 2. The embodiment is an application of the present invention to a projection exposure apparatus for semiconductor device manufacture wherein helium gas is supplied to the majority of the optical path of the exposure light.

Figure 1 shows the outline of the structure of the projection exposure apparatus of this embodiment and a portion of the helium circulation apparatus, while Figure 2 shows the outline of the structure of the main parts of this helium circulation apparatus; in Figures 1 and 2, a projection exposure apparatus is disposed within a clean room on a floor F1 of a certain floor of a semiconductor manufacturing plant, and a helium circulation apparatus, which supplies helium gas to the projection exposure apparatus on the upper floor and furthermore conducts recovery thereof, is installed within a machine chamber (utility space) on a floor F2 of a lower floor. In this way, the apparatus which is likely to give rise to particulate material and to be a source of vibration is installed on a different floor from that on which the projection exposure apparatus is installed, and thereby, it is possible to maintain the degree of cleanliness within the clean room in which the projection exposure apparatus is installed at an extremely high level and it is possible to reduce the effects of vibration with respect to the projection exposure apparatus to an extremely low level.

Helium gas is light and rises easily, so that the helium circulation apparatus of the present embodiment may be positioned at a higher floor than the floor in which the projection exposure apparatus is installed. Furthermore, the supply apparatus described hereinbelow within the helium circulation apparatus is disposed on floor F2, while the recovery apparatus is disposed on floor F1 or a higher floor, and in this way parts of the helium circulation apparatus may be disposed on differing floors.

First, on the floor F1 in the clean room in Figure 1, a box shaped case 1 is installed via vibration isolation platforms 2A and 2B and a F₂ laser light source 3 (oscillation wavelength 157 nm), as an exposure light source, a beam matching unit (BMU) 4 containing a movable mirror for positionally matching the optical path between the exposure main pans, and a pipe 5, which is formed from an optically insulating material and through the interior of which the exposure light passes, are installed within case 1. Furthermore, next to case 1, an environment chamber 7 which is box-shaped and has good airtightness is installed, and a fixed platform 24 is installed within this environment chamber 7 via vibration isolation platforms 25A and 25B which serve to reduce vibration from the floor on floor F1, and exposure main unit 26 is installed on fixed platform 24. Furthermore, a subchamber 6 which has good airtightness and extends from pipe 5 which extends from within case 1 to the interior of environment chamber 7 is installed in a framing manner, and the majority of the illumination optical system is stored within subchamber 6.

The F₂ laser light source 3 may be disposed on the lower floor F2. In this case, the surface area taken up by the projection exposure apparatus (the foot print) within the clean room on floor F1 can be reduced, and it is possible to reduce the effects of vibration to exposure main unit 26.

Furthermore, when a ArF excimer laser light (wavelength 192 nm) or KrF excimer laser light (wavelength 248 nm) or X-rays or the like are employed as the exposure energy beam (exposure light), as well, when helium or the like is supplied to at least a portion of the optical path of the exposure energy beam, the present invention may be applied. Furthermore, the exposure main unit 26 of the present embodiment is a scanning exposure type, for example, a step and scan type, as explained hereinbelow; however, it is of course the case that the present invention may be applied even if a stepping exposure type, for example, a step and repeat type, is employed.

First, when exposure is conducted, an ultraviolet pulse light IL having a wavelength of 157 nm which serves as the exposure light emitted from the F₂ laser light source 3 within case 1 travels through the interior of BMU 4 and pipe 5 and reaches the subchamber 6. In subchamber 6, the ultraviolet pulse light IL passes through a beam forming optical system comprising light reducer 8 as a light attenuator and lens systems 9A and 9B, and is applied to fly eye lens 11. An illumination system aperture stop system 12 for variously altering the illumination conditions is disposed at the plane of exit of fly eye lens 11.

The ultraviolet pulse light IL which is emitted from the fly eye lens 11 and passes through a predetermined aperture diaphragm in the aperture stop system 12 passes a reflection mirror 13 and a condenser lens system 14 and is inputted into a fixed illumination field diaphragm (fixed blind) 15A having a slit shaped opening within a reticle blind mechanism 16. Furthermore, a movable blind 15B which serves to change the width in the scanning direction in the illumination field region is disposed within reticle blind mechanism 16 separately from fixed blind 15A, and by means of this moveable blind 15B, a reduction in the movement stroke in the scanning direction of the reticle stage, and a reduction in the width of the light blocked band of the reticle R, are achieved.

The ultraviolet pulse light IL which is formed in a slit shape by the fixed blind 15A of the reticle blind mechanism 16 passes image forming lens system 17, reflection mirror 18 and main condenser lens system 19, and illuminates at an equal intensity a slit shaped illumination region on the circuit pattern of reticle R. In the present embodiment, the space from the output surface of pipe 5 comprising light insulating material to the main condenser systems 19 is contained within subchamber 6, and furthermore, the space from the inner part of pipe 5 to the output surface of the F₂ laser light source 3 is airtight, and communicates with the space within subchamber 6. Furthermore, helium gas (He) which has a specified purity or greater and is temperature controlled is supplied from two points from the helium circulation apparatus into the space within subchamber 6 via branch pipes 31a and 31b of pipe 31. Helium has a low molecular weight and is susceptible to leaking, so that a portion of the helium which naturally leaks out of subchamber 6 rises and collects in the space 7a in the vicinity of the ceiling of the environment chamber 7.

As shown in Figure 2, an opening and closing valve V11 is provided in pipe 31, and by controlling the opening and closing of the opening and closing valve V11 by control system 45, it is possible to switch among the supply and cut off of the helium gas to the projection exposure apparatus. Returning to Figure 1, an opening and closing valve V13 is provided in branch pipe 31a of pipe 31, and an opening and closing valve V14 is provided in branch pipe 31b in the space between it and the projection optical system PL, while an opening and closing valve V15 is provided in branch pipe 31b in the space between it and the illumination optical system (subchamber 6). Furthermore, the temperature controlled helium gas having a prespecified purity or greater is supplied into case 1, which contains the F₂ laser light source 3 and BMU 4, via another branch pipe 31c of pipe 31 (see Figure 2) and opening and closing valve V12. Then, by independently opening and closing the opening and closing valves V12 - V15 by means of the control system 45 in Figure 2, it is possible to supply helium gas into at least one desired destination: case 1, subchamber 6 (illumination optical system) and projection optical system PL.

On the basis of ultraviolet pulse light IL, the circuit pattern within the illumination region of reticle R is illuminated onto the slit shaped exposure region of the resist layer on a wafer W via projection optical system PL. This exposure region is positioned on one shot region within a plurality of shot regions on the wafer. The projection optical system PL in the present embodiment is a dioptric system (refraction system); however, since the glass which is able to transmit ultraviolet light having this type of short wavelength is limited, the projection optical system PL may be made a cata-dioptric system or a reflection system so as to increase the transmittivity of the ultraviolet pulse light IL in the projection optical system PL. In the following, a Z axis is obtained which is parallel to the optical axis AX of the projection optical system PL, and in a plane perpendicular to the Z axis, a X axis will be established which is parallel to the paper surface of Figure 1, and a Y axis will be established which is perpendicular to the paper surface of Figure 1.

At this time, reticle R is supported by vacuum on the reticle stage 20, and reticle stage 20 is made moveable at a constant velocity in the X direction (the scanning direction) on reticle base 21, and is installed so as to be capable of slight movements in the X direction, the Y direction, and the rotational direction. The two dimensional position of reticle stage 20 (reticle R) and the rotational angle thereof are controlled by a drive control unit, which is not depicted in the figure, which is provided with a laser interferometer.

On the other hand, wafer W is supported by vacuum on the wafer holder 22, and the wafer holder 22 is affixed to the wafer stage 23, while the wafer stage 23 is positioned on the fixed platform 24. The wafer stage 23 controls the focus position of wafer W (the position in the Z axis) in an auto focus manner, and controls the angle of inclination, so as to bring the surface of wafer W into agreement with the image plane of the projection optical system PL, and conducts the constant velocity scanning of wafer W in the X direction, and stepping in the X and Y directions. The two dimensional position of wafer stage 23 (wafer W) and the rotational angle thereof are controlled by means of a drive control unit which is not depicted in the figure and which is provided with a laser interferometer. During scanning exposure, reticle R is scanned at a velocity of Vr in the + X direction (or in the - X direction) with respect to the illumination area of the ultraviolet pulse light IL, via reticle stage 20, and synchronously therewith, this wafer W is scanned in the - X direction (or in the + X direction) at a speed of β·Vr (where β is the projection magnification from reticle R onto wafer W), with respect to the exposure region and via the wafer stage 23.

Furthermore, in the same manner as the interior of subchamber 6, temperature controlled helium gas having a predetermined concentration or greater is supplied to the entirety of the space within the barrel of the projection optical system PL of the present embodiment (the space between the plurality of lens elements), from the helium circulation apparatus in the lower floor and via branch pipe 31b of pipe 31 and opening and closing valve V14. The helium leaking from the barrel of the projection optical system PL rises and collects in the space 7a in the vicinity of the ceiling of the environment chamber 7.

Furthermore, in the present embodiment, temperature and pressure controlled nitrogen gas (N₂), the amount of oxygen contained in which is maintained at an extremely low level, is supplied from a nitrogen circulation apparatus (33-40, 82-87, 89, and the like) in a lower floor to the interior of environment chamber 7 via pipe 88. Then, the nitrogen gas circulating in the interior of the environment chamber 7 is recovered in pipe 33 via exhaust holes (not depicted in the figure) in the bottom surface of the environment chamber 7 and via pipe 95 which is connected to the side surface of the environment chamber 7, and the recovered nitrogen gas is returned to the nitrogen circulation apparatus as described hereinbelow. An opening and closing valve V19 is provided in the pipe 95.

In this way, in the present embodiment, helium gas which has a transmittivity with respect to light of 190 nm or less, as well, is supplied to the optical path of the ultraviolet pulse light IL from the output surface of the F₂ laser light source 3 to the main condenser lens system 19, as well as to the optical path of the ultraviolet pulse light IL within the projection optical system PL. Furthermore, the spaces from the main condenser lens system 19 to the plane of incidence of the projection optical system PL, and from the output surface of the projection optical system PL to the surface of the wafer W are supplied with nitrogen gas, which does not have very good transmittivity with respect to light of 190 nm or less; however, the optical path which passes through this nitrogen gas is extremely short, so that there is little absorption as a result of the nitrogen gas. Nitrogen gas has a higher transmittivity with respect to light having a wavelength within a range of approximately 200 nm - 150 nm in comparison with standard air (which is chiefly oxygen), and nitrogen gas is present in large amounts in the atmosphere, so that it is cheap in comparison with helium gas, so that superior cost performance can be obtained when nitrogen gas is used in the short optical path portion. Accordingly, the ultraviolet pulse light IL which is emitted from the F₂ laser light source 3 reaches the surface of wafer W at an overall high transmittivity (efficiency of use), so that it is possible to reduce the exposure period (scanning exposure period) and it is possible to increase the throughput of the exposure process.

Furthermore, helium has a thermal conductivity which is approximately six times that of nitrogen, so that the heat energy which is built up as a result of the application of the ultraviolet pulse light IL at the optical elements within the F₂ laser light source 3, the optical elements within the illumination optical system and the optical elements within the projection optical system PL is efficiently transmitted to, respectively, the case 1, the cover of the subchamber 6, and the barrel of the projection optical system PL via the helium gas. Furthermore, the heat energy of this case 1, the cover of the subchamber 6, and the barrel of the projection optical system PL is efficiently exhausted to the exterior, such as lower floors, or like, by temperature controlled air within the clean room or by temperature controlled nitrogen gas within the environment chamber 7. Accordingly, the rise in temperature of the optical elements of the illumination optical system and the projection optical system PL can be maintained at a very low level, and it is possible to control degradation and image formation characteristics at a minimum level. Furthermore, the amount of change in the index of refraction of helium in response to changes in air pressure is very small, so that the amount of change in the index of refraction within, for example, the projection optical system PL is extremely small and for this reason, as well, it is possible to maintain stable image formation characteristics.

Next, the helium circulation apparatus of the present embodiment will be explained in detail. In the interior of the environment chamber 7, the helium which leaks out of the subchamber 6 and the helium which leaks out of the projection optical system PL rises, since it is lighter than nitrogen, and collects in the space 7a in the vicinity of the ceiling. Here, the gas within the space 7a is a mixed gas in which are mixed, in addition to helium, nitrogen and air which enters the environment chamber 7 from the outside.

In the present embodiment a pipe 33 is connected to the space 7a from the exterior of the environment chamber 7, and this pipe 33 is connected to the helium circulation apparatus on the lower floor through a hole which is provided in floor F1. Furthermore, case 1 is connected to pipe 33 via pipe 92, and an opening and closing valve V16 is provided in pipe 92. Furthermore, the subchamber 6 which contains the illumination optical system, and the space within the projection optical system PL to which helium is supplied, are connected to pipe 33 via, respectively, pipes 93 and 94, and opening and closing valves V17 and V18, respectively, are provided in pipes 93 and 94. Accordingly, by independently opening and closing the opening and closing valves V16, V17, and V18 using the control system 45 shown in Figure 2, it is possible to recover helium gas containing organic matter or particles or the like from at least a desired one of the following: the case 1, the subchamber 6, and the projection optical system PL.

Furthermore, a suction type pump (or fan) 34 is disposed in the pipe 33 in the bottom surface side of floor F1, and the mixed gas sucked from the interior of the space 7a and the case 1 by pipe 33 and pump 34 is sent to the helium circulation apparatus of the lower level. Then, the mixed gas which is passed through pump 34 reaches the dust collecting and moisture removing apparatus 35, and here, in order to avoid later clogging of the adiabatic compression cooling passage, the fine particulate matter and moisture is removed. That is to say, in dust collecting and moisture removing apparatus 35, for example, a HEPA filter (high efficiency particulate air filter) or an ULPA filter (ultra low penetration air filter) is provided.

Furthermore, the mixed gas from which particulate matter or moisture has been removed by the dust collecting and moisture removing apparatus 35 passes through pipe 36 and reaches impurity removal apparatus 80, and here, impurities (contaminates) other than particulate matter or moisture contained in the mixed gas are removed. The impurities removed here are substances which precipitate onto the surfaces of the optical elements of the F₂ laser light source 3, the illumination optical system or the projection optical system PL and cause fogging, or substances which float within the optical path of the exposure light and which cause fluctuations in the transmittivity (illumination intensity) or illumination intensity distribution or the like of the illumination optical system or the projection optical system PL, or are substances which precipitate onto the surface of the wafer W (resist) and cause deformations in the pattern image after developing processing.

An activated carbon filter (for example, the Gigazobe (trade name) produced by Nitta Company), or a zeolite filter or a filter combining these, may be employed as the impurity removal apparatus 80 of the present embodiment. By means of this, silicon system impurities such as siloxane (substances having a Si-O chain as an axis) or silazane (substances having a Si-N chain as an axis), which are present within the environment chamber 7, the illumination optical system, or the projection optical system PL, may be removed.

Here, the substance known as "ring form siloxane", having a Si-O chain as an axis, which is one of the siloxanes, is contained in silicon system adhesives, sealing agents, paints, and the like, which are employed in projection exposure apparatuses, and with the passage of years, this is released as out gas. Ring form siloxane is easily deposited on the surfaces of light sensitive substrates or optical elements (lenses or the like), and oxidizes when it comes into contact with ultraviolet light, so that it becomes an Si0₂-system fogging substance on the surfaces of optical elements.

Furthermore, hexamethyldisilazane (hereinbelow referred to as "HMDS"), which is employed as a preprocessing agent in resist coating processes, is a silazane. HMDS is changed (hydrolyzed) into the substance silanol when it reacts with water. Silanol is easily deposited on the surfaces of light sensitive substrates or optical elements or the like, and oxidizes when it comes into contact with ultraviolet light, forming an Si0₂-system fogging substance on the surfaces of the optical elements. Silazane generates ammonia as a result of the hydrolysis described above; when such ammonia is present together with siloxane, the surfaces of optical elements are even more likely to be fogged.

The organic materials (for example, hydrocarbons) which are deposited on the surfaces of the optical elements of the illumination optical system or the projection optical system PL or the like are broken down by light cleaning, and become admixed into the helium gas; however, these hydrocarbons are also removed by the impurity removal apparatus 80 in the present embodiment. Furthermore, it is not the case that only the silicon system organic materials described above are generated; plasticizers (phthalates and the like) and flame retardants (phosphoric acid, and carbon system materials) may be generated as outgasses of the wiring or plastic within the environment chamber 7, but these plasticizers and flame retardants are also removed by the impurity removal apparatus 80 in the present embodiment. Even if ammonium ions or sulfuric acid ions or the like which float within the clean room enter into the environment chamber 7, these ions are also removed by the impurity removal apparatus 80. Furthermore, in the present embodiment, the impurity removal apparatus 80 is provided at the downstream side of the dust collection and moisture removal apparatus 35; however, this may also be provided at the upstream side of the dust collection and moisture removal apparatus 35, or alternatively, the HEPA filter or ULPA filter within the dust collection and moisture removal apparatus may be made unitary with the activated carbon filter within the impurity removal apparatus.

The mixed gas passing through the impurity removal apparatus 80 reaches the refrigerating apparatus 37 via pipe 36 and here, this is cooled to the temperature of liquid nitrogen by adiabatic compression cooling. By means of this, the nitrogen and air components are liquefied, and it is a simple matter to separate the gaseous helium from the liquefied air components containing nitrogen. The air components comprising chiefly nitrogen (N₂) liquefied within the refrigerating apparatus 37 are recovered in cylinder 40 of Figure 2 via pipe 38 and the suction type pump 39 disposed therein. The air components such as nitrogen and the like which are vaporized in the cylinder 40 may be reused (recycled). The helium which is present in the form of a gas within the refrigerating apparatus 37 of Figure 1 is sent to the first inflow port of the mixing and temperature adjustment apparatus 43 in Figure 2 via pipe 41 and a suction pump (or fan) 42 which is disposed therein.

In Figure 2, highly pure helium gas is supplied from cylinder 46, which is filled with highly pure helium gas at high pressure, to the second inflow port of mixing and temperature adjustment apparatus 43 via pipe 47 and opening and closing valve 48. Liquefied helium may be stored within cylinder 46. Furthermore, a helium concentration meter 44 for measuring the concentration (or purity) of the helium within the pipe 41 through which the helium recovered by the refrigerating apparatus 37 in Figure 1 passes is provided in the vicinity of the inflow port with respect to the mixing and temperature adjustment apparatus 43, and the measurement data thereof are supplied to the control system 45 which comprises a computer. When the concentration of the recovered helium measured by the helium concentration meter 44 reaches a predetermined allowable level, the control system 45 opens the opening and closing valve 48, and adds highly pure helium from the cylinder 46 into the mixing and temperature adjustment apparatus 43. Additionally, when the helium concentration as measured by the helium concentration meter 44 exceeds the allowable value, the control system 45 shuts the opening and closing valve 48. Furthermore, the opening and closing valve 48 is shut even when the exposure operation is not being conducted. It is possible to employ a sensor which detects the oxygen concentration in place of the helium concentration meter, and to close the opening and closing valve 48 when the oxygen concentration is at or below an allowable level.

Furthermore, mixing and temperature regulator apparatus 43 first mixes the recovered helium with helium from cylinder 46 within a predetermined pressure range and controls the temperature and humidity at a predetermined level and supplies the helium having controlled temperature, pressure, and humidity to pipe 31. The helium circulation apparatus of the present embodiment comprises from dust collection and moisture removal apparatus 35 to mixing and temperature adjusting apparatus 43. Furthermore, pipe 31 passes through an opening provided in the floor F1 of the upper level and reaches into the interior of the clean room, and a blowing pump (or fan) 32 is installed in the middle of pipe 31 at the bottom surface side of floor F1 and an opening and closing valve V11 is provided at the upper surface side of floor F1. Then, the helium gas which is placed within a predetermined pressure range, is at a predetermined concentration or greater, and the temperature, pressure, and humidity whereof are controlled at predetermined levels by mixing and temperature adjusting apparatus 43, is supplied to pipe 31, and then, while being blown by pump 32, is supplied to the interior of the subchamber 6 of the projection exposure apparatus on floor F1 of Figure 1, to the interior of the projection optical system PL, and the interior of case 1, via branch pipes 31a, 31b, and 31c of pipe 31.

Furthermore, in Figure 2, an impurity concentration meter 90 which detects the concentration of impurities (including the silicon system organic materials described above and the like) which enter into the helium gas is installed in pipe 31 at the upstream of the opening and closing valve V11 (the side of pump 32), and based on the values measured, control system 45 conducts the opening and closing of opening and closing valve V11, or in other words, the supply and cut off of helium. When the impurity concentration as measured by the impurity concentration meter 90 is in excess of a predetermined allowable level, then opening and closing valve V11 closes and the supply of helium to the projection exposure apparatus is cut off and, for example, the exchange of the filter of the impurity removal apparatus 80 of Figure 1 is conducted. Alternatively, the recovered helium may be sent to the helium circulation apparatus together with the impurities. After this, opening and closing valve V11 is opened and the supply of helium is reinitiated, and the opening and closing valves V12 - V18 of Figure 1 are opened and helium is circulated. Then, at a point in time at which, as an example, the impurity concentration is found to be at a level below the allowable level, the opening and closing valves V16 - V18 are closed. Furthermore, when the concentration of helium within the case 1, the subchamber 6, and the projection optical system PL reaches, respectively, predetermined values, opening and closing valves V12 - V15 are successively closed.

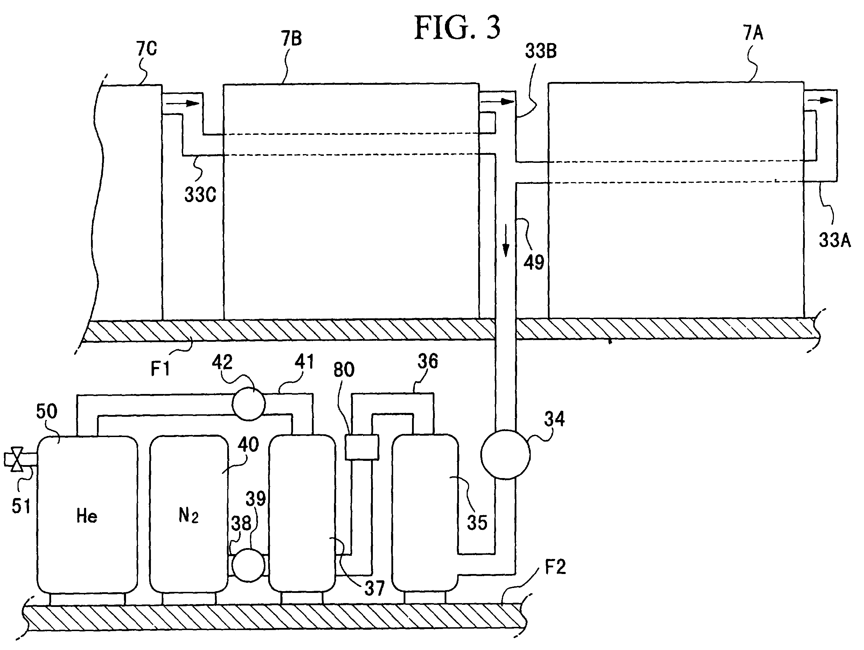

Next, using the light detector (not depicted in the figure) provided in the wafer stage 23 of Figure 1, the transmittivity with respect to the exposure light (ultraviolet pulse light IL) of projection optical system PL (or the illumination intensity on wafer W), and the illumination intensity distribution on reticle R or wafer W are detected, and based on the results of this detection, the exposure of wafer W is initiated. In place of the exchange of the filters or sending of the recovered helium described above, it is also possible to exchange the cylinder which serves to store to recovered helium (corresponding to the cylinder 50 in Figure 3 described hereinbelow) with another cylinder, and to increase the purity thereof at a separate regeneration facility, and to supply the helium of high purity within cylinder 46 to environment chamber 7. Furthermore, impurity concentration meter 90 may be installed at a position other than within the pipe 31, so that it may be installed within pipe 41 or pipe 36 at a point downstream from the impurity removal apparatus 80.

Furthermore, when the work of the projection exposure apparatus of the present embodiment is started up, or when the work is restarted after a long period of stoppage, or when the light cleaning of the projection optical system PL is initiated, or after this is completed, the opening and closing valve V11 in pipe 31 is closed by the control system 45 in Figure 2, and in the state in which the opening and closing valves V16 - V18 of pipes 92 - 94 in Figure 1 are opened, the gas within the case 1, the subchamber 6, and the projection optical system PL (helium or the like) is suctioned out by pump 34. At this time, so that the mixed gas within the upper space 7a of environment chamber 7 does not flow into the pipe 33, an opening and closing valve (not depicted in the figure) provided in the vicinity of the inflow port of pipe 33 should be closed. After this, the opening and closing valves V16 - V18 are closed, and the opening and closing valve V11 is opened, and helium is thus supplied to case 1, subchamber 6, and projection optical system PL, and when the interior parts thereof reach a predetermined helium concentration value, the corresponding opening and closing valves V12 - V15 are closed in order, and once all the opening and closing valves V12 - V15 have been closed, valve V11 is closed. By means of this, it is possible to initiate the exposure operation of wafer W, or to initiate the preparatory operations thereof.

Although not depicted in the figure, helium concentration meters and oxygen concentration meters are provided within the case 1, the subchamber 6, and projection optical system PL, and control system 45 controls the opening and closing of opening and closing valves V12 - V15 based on the output from these concentration meters. At this time, until the helium concentration in the case 1, subchamber 6, and the projection optical system PL, respectively, reach permitted values, or until the oxygen concentration is at a permitted value or below, the oscillation of the F₂ laser light source 3, that is to say, the exposure of the wafer W, is prohibited. Within the environment chamber 7, in particular, between the illumination optical system (condenser lens 19) and the projection optical system PL, and between the projection optical system PL and the wafer W, respectively, a nitrogen concentration meter and an oxygen concentration meter are disposed, and furthermore, the output of these concentration meters may be employed in common in the manner described above and the oscillation of the F₂ laser light source 3 may be controlled. Furthermore, when the helium concentration within at least one of the case 1, subchamber 6, and the projection optical system PL, for example, the helium concentration within the projection optical system PL, goes below a predetermined value during the operation of the projection optical apparatus, the opening and closing valves V11 and V14 are opened and helium is supplied. At this time, within the projection optical system PL, in particular so as not to change the pressure between the optical elements, the flow rate and pressure or the like of the helium gas supplied by the mixing and temperature adjustment apparatus 43 or the pump 32 or the like is adjusted. This is so as to prevent changes in the image forming characteristics of the projection optical system PL as a result of changes in pressure, and to prevent changes in the illumination intensity at the reticle R or the wafer W, or changes in the distribution thereof. Although not depicted in the figure, pressure sensors are disposed within the illumination optical system (subchamber 6) and the projection optical system PL, and control system 45 controls the flow rate and pressure of the helium gas based on the values measured by these pressure sensors. Temperature sensors and humidity sensors may further be disposed within the illumination optical system and projection optical system PL, and using the values measured by the sensors, the temperature or humidity of the helium gas may be precisely controlled.

In this way, in the present embodiment, the majority of the helium gas supplied so as to flow into the majority of the optical path of the exposure light (ultraviolet pulse light IL) of the projection exposure apparatus is directly recovered via the upper space 7a of the environment chamber 7 or from the case 1, subchamber 6, and the projection optical system PL, passing through pipe 33 to the helium circulation apparatus of the lower level, so that the amount of high cost helium employed can be reduced. It is possible to increase the transmittivity with respect to the exposure light, and to increase the cooling efficiency of the optical elements, and it is also possible to reduce the operating costs of the projection exposure apparatus.

In the embodiment described above, a cylinder (corresponding, for example, to the cylinder 50 of Figure 3 described hereinbelow) for storing recovered helium may be provided between the refrigerating apparatus 37 and the mixing and temperature adjustment apparatus 43 in Figure 1. In this case, in order to be able to store large amounts, the helium should be compressed using a compressor to 100 to 200 atmospheres, and stored in the cylinder. By means of this, the volume is reduced to a range of approximately 1/100th to 1/200th. Furthermore, the helium may be liquefied by means of a liquefier employing a turbine or the like and stored. By means of liquefaction, the volume of the helium may be reduced to approximately 1/700th. When helium highly compressed or liquefied in this manner is reused, for example, when it is returned to state of approximately one atmosphere, the temperature decreases as a result of expansion, so that it is necessary to employ heating temperature management using a heater or the like. Furthermore, a buffer space for maintaining a constant pressure is desirably provided. Furthermore, an opening and closing valve may be provided on the upstream side of the mixing and temperature adjustment apparatus 43 (the side of pump 42), and the amount of helium obtained from the cylinder which stores the recovered helium may be regulated, or the opening and closing of the flow path (pipe 41) may be controlled. By employing this opening and closing valve together with the opening and closing valve 48 of the pipe 47, it is possible to more easily conduct the regulation of the concentration of helium sent to pipe 31.

In the embodiment described above, the helium gas is supplied in such a manner as to flow through the majority of the optical path of the exposure light; however, in order to cover the entirety of the optical path, and to increase the cooling efficiency of the reticle stage 20 and the wafer stage 23, helium gas may be supplied to the entirety of the interior of the environment chamber 7. In this case, as well, the majority of the helium may be recovered, so that the increase in operating costs is slight.

Furthermore, in the embodiment described above, the helium recovered by the mixing and temperature adjusting apparatus 43 is mixed with highly pure helium; however, when the concentration (purity) of the recovered helium is low, there is a danger that simply by mixing it will be impossible to rapidly increase the concentration of the helium supplied to the projection exposure apparatus to allowable ranges. In such cases, the recovered helium may be stored in a separate cylinder, and the purity thereof may be increased at a separate regeneration facility, and the highly pure helium within cylinder 46 may be supplied to the projection exposure apparatus.

In the projection exposure apparatus of Figure 1, using the opening and closing valves V11 - V18, helium was filled (sealed) within the case 1, the subchamber 6, and the projection optical system PL; however, in the present embodiment, a helium circulation apparatus is provided, so that in the state in which the opening and closing valves V16 - V18 are closed, the helium leaking out of the case 1, the subchamber 6, and the projection optical system PL may be replenished, and a constant supply may be carried out while regulating the flow rate of the helium. Alternatively, the helium may be constantly supplied at a predetermined flow rate while keeping the opening and closing valves V11 - V18 open. Using the latter method, the opening and closing valves V11 - V18 need not be provided. At this time, based on the values measured by pressure sensors (not depicted in the figure) provided within, respectively, the illumination optical system and the projection optical system PL, the flow rate and pressure and the like of the helium supplied may be controlled so as to maintain the interior pressure at a constant value.

Here, when the helium is constantly supplied as described above, the opening and closing valve V11 closes at the point in time at which the predetermined permitted value of the impurity concentration measured by the impurity concentration meter is reached; however, at this time, the main control system (not depicted in the Figure) which controls the operations of the entire projection exposure apparatus confirms the operation in the main part of the exposure apparatus, and when, for example, the exposure process of the wafer is in progress, this control system sends a directive so as to delay the operation closing the opening and closing valve V11 (closing) until the completion of the exposure processing, with respect to the control system 45. Alternatively, immediately prior to reaching the permitted value of the impurity concentration, the main control system may close the opening and closing valve V11 without initiating the subsequent wafer exposure process and may initiate operations which reduce the impurity concentration below a predetermined value as described above.

Furthermore, taking into account the admixture of impurities as described above in the present embodiment, in order to exchange the helium within the case 1, the subchamber 6, and the projection optical system PL, or in order to circulate the helium, the case 1, subchamber 6, and the projection optical system PL are connected with pipe 33 via pipes 92 - 94. However, if the recovered helium can be cleaned so as achieve good purity (purified), the admixture of impurities is at a level that can be ignored, or the state is such that the impurities are essentially not generated within the illumination optical system or projection optical system PL, then it is not necessary to provide these pipes 92 -94 (and opening and closing valves V16 - V18). At this time, opening and closing valves V11 - V15 also need not be provided. In this case, helium leaks out from the case 1, the subchamber 6, and the projection optical system PL, so that helium may be supplied either constantly or when needed (or at regular intervals) so as to replenish the helium and to maintain the helium concentration at a permitted value or above.

Furthermore, in the present embodiment, the F₂ laser light source 3 and the BMU 4 were contained in case 1 of Figure 1; however, the BMU 4 and the like may be contained in a housing separately from the F₂ laser light source 3, and helium may be supplied respectively to the F₂ laser light source 3 and to this housing. At this time, the F₂ laser light source 3 and this housing may be mechanically connected, and a glass plate may be provided which allows the transmission of a F₂ laser as a dividing plate between the two.

Next, the nitrogen circulation apparatus of the present embodiment will be explained in detail. In the present embodiment, nitrogen gas (N₂) is supplied within the environment chamber 7 of Figure 1 via the pipe 88 of Figure 2, and nitrogen is recovered from the environment chamber 7 via pipes 95 and 33, so that in other words, nitrogen is circulated within the environment chamber 7.

The nitrogen which is separated from the helium and the like by the refrigerating apparatus 37 of Figure 1 is suctioned away by pump 39 and passes through pipe 38 and is recovered in cylinder 40 of Figure 2. Furthermore, the nitrogen within the cylinder 40 is suctioned by pump 83 and passes through pipe 81 and is sent to the temperature adjusting apparatus 86. An opening and closing valve V21 is provided in pipe 81, and nitrogen concentration meter, or oxygen concentration meter, 82 which measures the concentration of nitrogen sent to the temperature adjusting apparatus 86 is provided, and the values measured by this concentration meter are supplied to the control system 45. When the nitrogen concentration as measured by the concentration meter 82 reaches a predetermined value, the control system 45 opens the opening and closing valve V22 of the pipe 85 connecting the nitrogen cylinder 84 and the temperature adjusting apparatus 86, supplying highly pure nitrogen from cylinder 84 to temperature adjusting apparatus 86. On the other hand, when the nitrogen concentration is at the predetermined value or above, the control system 45 maintains the opening and closing valve V22 in a closed state. When the nitrogen concentration measured by the concentration meter 82 is extremely low, the opening and closing valve V21 may be closed and a flow of nitrogen from only the nitrogen cylinder 84 may be sent to the temperature adjusting apparatus 86. Then, when the nitrogen concentration as measured by the concentration meter 82 reaches a permitted value (a value smaller than the predetermined value described above), the opening and closing valve V21 may be opened.

Furthermore, temperature adjusting apparatus 86 mixes the recovered and cleaned nitrogen and the nitrogen from the nitrogen cylinder 84 and controls the temperature, pressure, and humidity thereof at predetermined levels, and supplies this nitrogen gas having controlled temperature, pressure, and humidity to a pipe 88 which passes through floor F1. A blowing pump (or fan) 87 is provided in the bottom side surface of floor F1 in pipe 88, and the nitrogen is supplied to the interior of the environment chamber 7 by this pump 87 via the branch pipes 88a and 88b of pipe 88 of Figure 1. Branch pipe 88a blows nitrogen gas in the direction of the optical path of the exposure light between the projection optical system PL and the wafer W, while branch pipe 88b blows nitrogen gas in the direction of the optical path of the exposure light between the subchamber 6 and the projection optical system PL (the space above and below the reticle R).

Furthermore, an opening and closing valve V23 is provided in pipe 88 at the side of the upper surface of floor F1, and an impurity concentration meter 89 which detects the concentration of impurities (including the silicon system organic materials or the like described above) which are mixed into the nitrogen is provided in the pipe 88 at the upstream side of the opening and closing valve V23 (the side of pump 87). When the impurity concentration as measured by this impurity concentration meter 89 is at or above predetermined allowable levels, then control system 45 closes the opening and closing valve V23 and halts the supply of nitrogen to the projection exposure apparatus, and the exchange of the filter of impurity removal apparatus 80, for example, is conducted. Alternatively, the recovered nitrogen may be sent out of the nitrogen circulation apparatus together with the impurities. After this, the opening and closing valve V23 (and the opening and closing valves V24 and V25) is opened, and the supply of nitrogen is resumed and the opening and closing valve V19 of pipe 95 in Figure 1 is opened, and nitrogen is circulated. Then, when it is confirmed that the impurity concentration is lower than an allowed value, the opening and closing valve V19 is closed. Furthermore, when the nitrogen concentration within the environment chamber 7 reaches a predetermined value, the opening and closing valves V24 and V25 are successively closed. Then using a light detector (not depicted in the figure) provided at wafer stage 23, the transmittivity of the projection optical system PL (or the illumination intensity on wafer W) is detected, and furthermore, the illumination intensity distribution on reticle R or wafer W is detected, and based on these detection values, the exposure of the wafer W is initiated.

In the embodiment described above, when the nitrogen concentration within the environment chamber 7 reaches a predetermined value, the supply of nitrogen is halted, and the opening and closing valve V23 (or the valves V24 and V25) and the opening and closing valve V19, respectively, of the pipe 88 (or the branch pipes 88a and 88b) and the pipe 95 are closed, and when the nitrogen concentration within the environment chamber 7 drops below the predetermined value, the opening and closing valve V23 (or the opening and closing valves V24 and V25) may be opened and nitrogen supplied.

Furthermore, in place of the filter exchange or the discharge of the recovered nitrogen described above, the cylinder 40 storing the recovered nitrogen may be exchanged with another cylinder, and the purity thereof may be increased at a separate regeneration facility, and the highly pure nitrogen within the nitrogen cylinder 84 may be supplied to the environment chamber 7. Furthermore, the impurity concentration meter 89 may be disposed at a position other than within the pipe 88, so that for example, it may be disposed within pipe 81 or within pipe 36 at a position downstream from the impurity removal apparatus 80. In particular, with the latter distribution, it is no longer necessary to provide the impurity concentration meter 90 described above; that is to say, the helium supply apparatus and nitrogen supply apparatus may commonly employ a single impurity concentration meter.

Furthermore, although it is not depicted in the figure, a nitrogen concentration meter or an oxygen concentration meter may be provided within environment chamber 7, and control system 45 may control the opening and closing of opening and closing valves V23 - V25 based on the outputs of these concentration meters so that the nitrogen concentration within the environment chamber 7 does not drop below a predetermined permitted value. Furthermore, temperature sensors, pressure sensors, and humidity sensors (not depicted in the figure) are disposed within the environment chamber 7, and based on the measured values of the sensors, the control system 45 regulates the flow rate, temperature, pressure, and humidity of the nitrogen supplied using temperature adjusting apparatus 86 and pump 87 and the like so as to maintain at an essentially fixed value the temperature, pressure, and humidity within the environment chamber 7.

In the present embodiment, in Figure 1, an exhaust port of a first branch pipe 88a of pipe 88 is disposed in the vicinity of projection optical system PL and wafer W, and nitrogen flows to the space between the projection optical system PL and the wafer W. On the other hand, the second branch pipe 88b of the pipe 88 further branches in two, and one exhaust port is disposed in the vicinity between condenser lens 19 and reticle R, while the other exhaust port is positioned between the reticle R and the projection optical system PL. The opening and closing of opening and closing valve V19 may be controlled and nitrogen caused to circulate within the environment chamber 7 so as to constantly blow nitrogen from branch pipes 88a and 88b. In this case, it is possible to supply nitrogen having a high degree of purity in a prioritized manner between the illumination optical system (condenser lens 19) and the projection optical system PL, and between the projection optical system PL and the wafer W, so that even if the nitrogen concentration within the environment chamber 7 decreases as a result of opening this chamber during the exchange of reticles R or wafer W, after the completion of the exchange operation, it is possible to rapidly initiate an exposure operation or a preparatory operation, so that it is possible to restrict the decline in throughput to the minimum possible period. Furthermore, in comparison with the case in which nitrogen is circulated by simply connecting pipe 88 to the environment chamber 7 without providing branch pipes 88a and 88b, it is possible to reduce the amount of nitrogen employed. Furthermore, it is possible to greatly reduce the deposition of scattered particles (particulate matter), generated from the wafer W (resist surface) during illumination with exposure light, onto the projection optical system PL (surfaces of the optical elements closest to the wafer side). When nitrogen is circulated within the environment chamber 7, the contaminant substances are exhausted to the outside together with the nitrogen, so that it is possible to improve the cleanliness within the environment chamber 7.

In the present embodiment, the interior of environment chamber 7 was made a nitrogen atmosphere; however, air from which impurities have been removed may be supplied to environment chamber 7, and as described above, nitrogen may be supplied between the illumination optical system and the projection optical system PL, and between the projection optical system PL and the wafer W, and thus only these two spaces may be given nitrogen atmospheres. At this time, helium may be supplied in place of nitrogen, and in such a case, it is no longer necessary to provide a nitrogen circulation apparatus, so that, for example, the helium may be supplied to the spaces described above by connecting pipe 31 with branch pipes 88a and 88b. Furthermore, chemically clean dry air (having a humidity of 5% or less) from which the organic materials described above have been removed may be employed as the air which is supplied to the environment chamber 7. Such a structure is particularly effective for projection exposure apparatuses which employ a ArF excimer laser as the exposure light source, and in this case, nitrogen may be supplied to the case 1, the subchamber 6, and the projection optical system PL, or alternatively, nitrogen may be supplied to the case 1, and to subchamber 6, while helium is supplied to the projection optical system PL.

Furthermore, in the present embodiment, nitrogen (or helium) or the like was supplied to the interior of the environment chamber 7; however, depending on the wavelength band of the exposure illumination light, temperature controlled air which is chemically clean (the dry air described above) may solely be supplied to the interior of the environment chamber 7. For example, if the exposure wavelength is approximately 190 nm or greater, the interior of the environment chamber 7 may be given an air atmosphere. In this case, in the same way as with the circulation apparatus for recovering helium or nitrogen or the like which was supplied to the case 1, the subchamber 6, and the projection optical system PL, a dry air circulation apparatus for recovering the dry air supplied to the environment chamber 7 may be provided, and the environment chamber 7 and the dry air circulation apparatus may be connected solely by means of pipe 95 without interposing a pipe 33.

Furthermore, in the same way as the helium circulation apparatus described above, the recovered nitrogen may be compressed using a compressor to 100 - 200 atmospheres, or alternatively, this may be liquefied using a liquefier employing a turbine or the like and stored in cylinder 40. The opening and closing valves V24 and V25 which are provided in, respectively, branch pipes 88a and 88b, make it possible to supply nitrogen to only one of the spaces between the illumination optical system and the projection optical system PL, or between the projection optical system PL and wafer W, and when nitrogen is simultaneously supplied to both places, the opening and closing valves V24 and V25 need not be provided.

Furthermore, in the present embodiment, nitrogen is caused to flow between the illumination optical system and the projection optical system PL, and between a projection optical system PL and the wafer W; however, the environment chamber 7 may simply be connected to the pipe 88 without providing branch pipes 88a and 88b, and when the nitrogen concentration within the environment chamber 7 reaches a predetermined value or greater, the opening and closing valve V23 may be closed. Furthermore, irrespective of the existence of the branch pipes 88a and 88b, nitrogen may be supplied at a predetermined flow rate while the opening and closing valves V23 and V19 are opened, and nitrogen may thus be caused to circulate in the environment chamber 7. In this case, it is not particularly necessary to provide the opening and closing valves V23 and V19.

Furthermore, in the present embodiment, the majority of the illumination optical system was contained in the subchamber 6, and a portion of subchamber 6 was disposed within the environment chamber 7; however, the entirety of the subchamber 6 may be disposed within the environment chamber 7. In this case, it is possible to increase the recovery ratio of helium leaking from the subchamber 6. Furthermore, in order to also recover the helium leaking from that portion of the subchamber 6 which is disposed outside the environment chamber 7, the subchamber 6 outside the environment chamber 7 may be covered by a predetermined housing, and another inflow port of pipe 33 may be connected to the upper part of this housing.

Furthermore, in the present embodiment, only a single gas (nitrogen or helium) was supplied to the case 1, subchamber 6, and the projection optical system PL, respectively; however, it is also possible to supply a gas consisting of a mixture of nitrogen and helium at predetermined proportions. In this case, the pipe 88 of the nitrogen circulation apparatus may be connected to the pipe 31 of the helium circulation apparatus at the downstream side of the opening and closing valve Vll. The mixed gas is not restricted to a combination of nitrogen and helium; neon, hydrogen, or the like may be combined. Furthermore, the gas supplied to the environment chamber 7 may also be the mixed gas described above.

Next, a second embodiment of the present invention will be explained with reference to Figure 3. This embodiment is one in which helium from a plurality of projection exposure apparatuses is recovered by a single helium recovery apparatus; in Figure 3, the parts corresponding to those in Figures 1 and 2 are given identical reference numbers, and a detailed description thereof is omitted. The pipes 92-94 which connect the case 1, subchamber 6, and projection optical system PL shown in Figures 1 and 2 with the pipe 33, respectively, and the pipe 95, which connects the environment chamber 7 and the pipe 33, are not depicted in the figure.

Figure 3 is a cross sectional view showing a plurality of projection exposure apparatuses and a single helium recovery apparatus in accordance with this embodiment; in Figure 3, environment chambers 7A, 7B, and 7C are disposed on floor F1, and exposure main units identical to the exposure main unit 26 of Figure 1 are installed in each of the environment chambers 7A, 7B, and 7C, and exposure light sources which are not depicted in the figure are disposed in close proximity. Helium gas having a predetermined purity or greater is supplied to environment chambers 7A, 7B, and 7C from a helium supply apparatus on the lower floor which is not depicted in the figure. Then, the mixed gas of helium, nitrogen, and air which is supplied to the environment chambers 7A, 7B and 7C rises to the space in the vicinity of the ceiling of the interior thereof and is supplied via pipes 33A, 33B, and 33C to the common pipe 49. Common pipe 49 passes through an opening in floor F1 and travels to the helium recovery apparatus on floor F2 of the lower level. A suction pump 34 is installed in common pipe 49 at the bottom surface of floor F1.

In the helium recovery apparatus of the lower level, the mixed gas of helium, nitrogen, and air recovered via common pipe 49 and the suction pump 34 travels through the dust collecting and moisture removing apparatus 35, the impurity removal apparatus 80 and the pipe 36 and reaches the refrigerating apparatus 37, and the nitrogen liquefied at the refrigerating apparatus 37 is recovered in cylinder 40. The helium which is not liquefied by the refrigerating apparatus 37 is stored, for example under compression at high pressures, in the cylinder 50 for storing the helium via pipe 41 and suction pump 42. The recovered helium is supplied via the pipe 51 provided in the cylinder 50 to a regeneration facility for increasing the purity thereof or to the helium supply apparatus shown in Figure 1.

As explained in the first embodiment (Figures 1 and 2) described above, the helium recovery apparatus (33A through 33C, 34-42, 49, 50) in Figure 3 is combined with a nitrogen recovery apparatus. A plurality of projection exposure apparatuses may be connected with a single nitrogen supply apparatus (the parts in Figure 2 from pipe 81 to pipe 88), and the nitrogen stored in the cylinder 40 may be supplied to the plurality of projection exposure apparatuses via this nitrogen supply apparatus. By means of this, it is possible to employ a single nitrogen circulation apparatus for a plurality of projection exposure apparatuses.

In this way, in the present embodiment, a single helium recovery apparatus and nitrogen circulation apparatus corresponds to a plurality of exposure apparatuses, so that recovery costs are reduced.

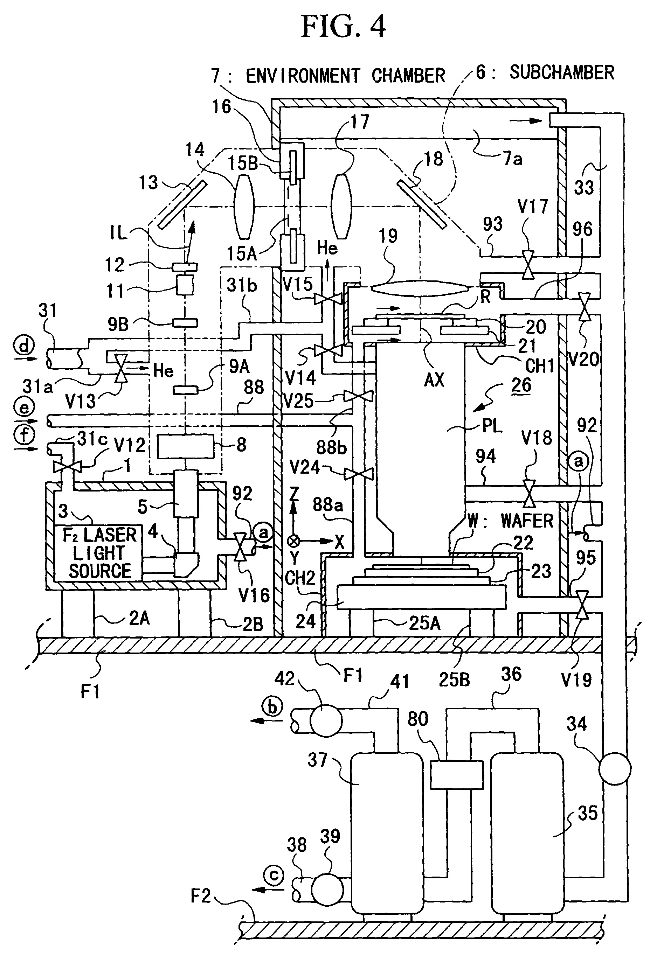

Next, a modification of the projection exposure apparatus of the first embodiment shown in Figures 1 and 2 will be explained with reference to Figure 4. In this embodiment, the reticle stage 20 and wafer stage 23 which are disposed within environment chamber 7 are contained in subchambers CH1 and CH2; in Figure 4, those parts which correspond to parts in Figure 1 are given identical reference numbers, and a detailed explanation thereof is omitted.

In Figure 4, so as not to expose the optical path between the illumination optical system (condenser lens 19) and the projection optical system PL to the air, subchamber CH1 encloses the space therebetween and is given a nitrogen atmosphere, and is connected to a branch pipe 88b of pipe 88 and pipe 96 which is connected to pipe 33, and an opening and closing valve V20 is provided in pipe 96. In Figure 4, subchamber CH1 is connected with projection optical system PL; however, in actuality, a structure is formed such that the vibration of subchamber CH1 is not communicated to the projection optical system PL. Subchamber CH1 may be formed so as to be integral with the subchamber 6, and furthermore, subchamber CH1 may be affixed on floor F1 via a frame which is different than the frame which affixes the projection optical system PL.

Subchamber CH2 is affixed on floor F1 (actually, on the base plate on which the exposure apparatus main body is installed), and, so that the optical path between the projection optical system PL (the optical elements closest to the wafer side) and the wafer W is not exposed to air, subchamber CH2 seals this space and is given a nitrogen atmosphere and is connected to the branch pipe 88a of pipe 88 and to pipe 95. Furthermore, as in the subchamber CH1, CH2 has a structure such that the vibration thereof is not communicated to the projection optical system PL.

In subchambers CH1 and CH2 at the point in time at which the nitrogen concentration of the interior thereof reaches a predetermined level or above, the opening and closing valves before and after (opening and closing valves V25 and V20, or opening and closing valves V24 and V19) may be closed, or alternatively, nitrogen may be circulated at a constant flow rate while these opening and closing valves are opened. Furthermore, branch pipes of the pipe 31 are connected to subchambers CH1 and CH2, and helium may be supplied in place of nitrogen.

Although not depicted in the Figure, at least one of the following is installed in subchamber CH2: a laser interferometer for detecting the positional data of wafer stage 23, an off axis type alignment optical system for detecting the alignment marks and the like on wafer W, or a oblique incidence light type positional detecting optical system for detecting the surface position of wafer W. It is preferable that the light source of the alignment optical system or the positional detecting optical system, as well as the detector and the like, be disposed outside subchamber CH2. Furthermore, laser interferometers (not depicted in the figure) used in the control of the position of reticle stage 20 and wafer stage 23 are disposed in, respectively, subchambers CH1 and CH2.

Furthermore, in the present embodiment, an air conditioner (not depicted in the figure) is connected to circulation chamber 7, and air from which the impurities described above (organic matter and the like) have been removed and which has controlled temperature, pressure, and humidity, is circulated in the spaces other than the subchambers 6, CH1, and CH2, and thus the environment (temperature and the like) within the environment chamber 7 is maintained in an essentially constant manner. The pressure within subchambers CH1 and CH2 should be set so as to be higher than the pressure within the environment chamber 7 so that the air within the environment chamber 7 does not mix into the subchamber CH1 and CH2.

In this way, in the present embodiment, it is possible to prevent attenuation of the exposure light (ultraviolet pulse light IL) between the illumination optical system and the projection optical system PL, as well as between the projection optical system PL and the wafer W, and in comparison with the case in which a nitrogen atmosphere is provided in all the interior spaces of the environment chamber 7, the amount of nitrogen supplied (amount used) is comparatively small, and it is possible to efficiently exhaust, to the exterior of subchamber CH2, the contaminant substances generated at the surface of the resist by the application of the exposure light. The structure of this embodiment is identical to that of Figure 1 with the exception of subchambers CH1 and CH2 and the air conditioner described above, and the modifications described in the first and second embodiments may also be applied here. For example, it is possible to extend the branch pipe 88a within the subchamber CH2, and blow (flow) nitrogen between the projection optical system PL and the wafer W in the same way as in Figure 1, and by means of this, it is possible to reduce the amount of contaminant materials which adhere to the projection optical system PL, and it is possible to efficiently conduct the recovery (exhaust) of these contaminant materials. In the present embodiment, nitrogen or helium was respectively supplied to the subchambers CH1 and CH2; however, other inert gases (neon, hydrogen, or the like) or mixed gases representing combinations thereof may be supplied, or alternatively, depending on the wavelength of the exposure light (for example, when the wavelength is approximately 190 nm or greater), the chemically clean dry air described above may be supplied. Furthermore, in place of supplying nitrogen or the like to subchambers CH1 and CH2, the interior thereof may be made into a vacuum.

In the projection exposure apparatuses shown in Figures 1 through 4, neither an alignment optical system or a oblique incidence light type focal point detection optical system is depicted; however, in the same way as with the subchamber 6 which contains the majority of the illumination optical system, these may be contained within a housing corresponding to at least a portion of the alignment optical system or the focal point detection optical system, and nitrogen or helium may be supplied to the interior of this housing. In this case, the housing may be connected to branch pipes of pipe 31 or pipe 88, and furthermore, where necessary, the housing may be connected with the pipe 33.

Furthermore, the reticle loader which transports the reticle R to the reticle stage 20, and the wafer loader which transports the wafer W to the wafer stage 23, are not depicted; however, the reticle loader and the wafer loader are independently contained in the subchambers, and these subchambers are connected to the environment chamber 7 (in the example shown in Figure 4, the subchambers CH1 and CH2). In this case, for example, branch pipes of the pipe 88 may connected to the subchambers so as to supply nitrogen, or dry air or the like, to the interior of the subchambers in which the reticle loader and the wafer loader are disposed or alternatively, air which has the impurities thereof described above removed therefrom and the temperature and the like of which is controlled may be supplied to the interior of the chambers. In the former option, the structure may be such as to permit the circulation of nitrogen by connecting the subchambers with pipe 33, while with the latter option, when nitrogen, helium, or dry air or the like is supplied to, in particular, the environment chamber 7 (subchambers CH1 and CH2), the pressure within the environment chamber 7 (or the subchambers CH1 and CH2) should be set higher than the pressure within the subchambers so that air does not flow into the subchambers in which the reticle holder and wafer holder are disposed.

Furthermore, in the embodiment described above, nitrogen or helium is supplied to environment chamber 7 or to subchambers CH1 and CH2, so that when the measured value of the oxygen concentration meter disposed in the interior goes below a predetermined value (for example, the approximate oxygen concentration in air), the doors of the environment chamber 7, or of the subchambers CH1 and CH2, are locked so that they can not be opened by the operator. Furthermore, when the supply of electrical power is halted or the like, the supply of nitrogen or helium is automatically halted, and the opening and closing valves (normally closed valves) of the exhaust ducts connected to environment chamber 7 or subchambers CH1 and CH2 separately from the recovery pipe 95 are opened, and the concentration of nitrogen or helium in the interior decreases. Furthermore, when the operator opens environment chamber 7 or subchambers CH1 and CH2, the supply of nitrogen or helium is halted, and an oxygen cylinder is connected so as to supply oxygen to the interior thereof. By means of this, it is possible to shorten the time required to reach the predetermined value of the oxygen concentration described above. Here, the stoppage of the supply of the inert gas described above (nitrogen or helium or the like) is conducted when the environment chamber 7, the subchamber 6, CH1, CH2 or the case 1 is opened, or in other words, when maintenance is performed on the exposure apparatus (for example, the F₂ laser light source 3, the illumination optical system, the projection optical system PL, the reticle stage 20, and the wafer stage 23 or the like), or when the wafer cassette or reticle case is exchanged, and when the supply of electrical power to the exposure apparatus is cut off. At this time, simultaneous with the stoppage and supply of the inert gas, the chemically clean dry air described above is supplied to, respectively, the case 1, the subchamber 6, and the projection optical system PL, and it is desirable that the occurrence of fogging at the surfaces of the optical elements which accompany a stoppage in the supply of inert gases thus be prevented.

The exhaust duct described above which is connected to the environment chamber 7 separately from the pipe 95 has a much larger exhaust capacity in comparison with the pipe 95, in order to rapidly increase the oxygen concentration within the environment chamber 7 to the predetermined value described above or above this value. Furthermore, the other end of this exhaust duct may open to the outside of the clean room (the semiconductor facility), that is to say, to the atmosphere; however, it is desirable that it be connected to a large capacity tank or the like and that the inert gas be recovered. The inert gas recovered in this tank may be sent to the helium recovery apparatus described above through pipes, or the purity thereof may be increased by a regeneration apparatus.

Furthermore, in the embodiment of the present invention described above, helium gas is employed as the gas having high transmittivity with respect to the exposure energy beam (is inert) and which has good thermal conductivity; however, the present invention may be applied even when gases other than helium (for example, neon (Ne), hydrogen (H₂), or a mixed gas of helium and nitrogen or the like) are used as this gas. Furthermore, in exposure apparatuses employing exposure light having a wavelength of, for example, 190 nm or more, it is possible to employ nitrogen (particularly of higher purity) as the gas supplied to the projection optical system PL; however, the present invention may be applied in these cases as well.

Furthermore, in the embodiment of the present invention described above, a F₂ laser was employed as an exposure light source; however, a KrF excimer laser (wavelength 248 nm), a ArF excimer laser (wavelength 193 nm), a Kr₂ laser (wavelength 147 nm) or Ar₂ laser (wavelength 126 nm) or the like may be employed, and the present invention may be applied with respect to exposure apparatuses provided with such light sources, as well. However, in exposure apparatuses employing, for example, KrF excimer lasers, it is not necessary to exchange the air within the projection optical system for nitrogen or helium or the like, and only the air of the KrF excimer laser source and the air within the illumination optical system need be replaced with nitrogen or the like. Furthermore, it is not necessary that the gas supplied to the environment chamber 7 be nitrogen or the like; it is possible to use the air from which impurities have been removed which is described above. The present invention may be applied even in the case of a exposure apparatus which supplies nitrogen or the like only to the light source and the illumination optical system, or only to the illumination optical system. In this type of exposure apparatus, in place of nitrogen, it is possible to employ the chemically clean dry air described above; however, it is possible to apply the present invention to exposure apparatuses which employ dry air as well.

Furthermore, the present invention is also applicable to the case in which, in place of the excimer laser, a wavelength of, for example, 248 nm, 193 nm, or 157 nm, or the higher harmonics of a solid state laser such as a YAG laser having an oscillation spectrum in the vicinity thereof, is used as the excitation light. Furthermore, the present invention is even applicable in the case in which a single wavelength laser in the inferred band or in the visible band oscillating from, for example, an DFB semiconductor laser or fiber laser is amplified by a fiber amplifier which is doped, with, for example, erbium (Er) (or both erbium and ytterbium (Yb)), and the higher harmonics resulting from wavelength conversion to ultraviolet light using a non-linear optical crystal is employed as the excitation light.

Concretely, when the excitation wavelength of the single wavelength laser is set within a range of 1.51 - 1.59 µm, then the 8-fold higher harmonic having a generated wavelength within a range of 189 - 199 nm or the 10-fold higher harmonic having a generated wavelength within a range of 151 - 159 nm is outputted. In particular, when the oscillation wavelength is within a range of 1.544 - 1.553 micrometers, then the 8-fold higher harmonic within a range of 193 - 194 nm, that is to say, ultraviolet light having approximately the same wavelength as that of a ArF excimer laser, is obtained, while when the oscillation wavelength is within a range of 1.57 - 1.58 micrometers, then the 10-fold higher harmonic within a range of 157 - 158 nm, that is to say, ultraviolet light having essentially the same wavelength as that of a F₂ laser, is obtained.

Furthermore, when the oscillation wavelength is set within a range of 1.03 - 1.12 micrometers, ten the 7-fold higher harmonic having a generated wavelength within a range of 147 - 160 nm is outputted, and in particular, when the oscillation wavelength is within a range of 1.099 - 1.106 micrometers, then the 7-fold higher harmonic having a generated wavelength within a range of 157 - 158 nm, that is to say, ultraviolet light having essentially the same wavelength as that of the F₂ laser, is obtained. It is possible to use a ytterbium doped fiber laser or the like as the single wavelength oscillating laser.

Furthermore, the exposure apparatus to which the present invention is applied may be either a stepping exposure type (for example, a step and repeat type) or a scanning exposure type (for example, a step and scan type). Furthermore, the present invention can be applied to exposure apparatuses of the mirror projection type or the proximity type. When a projection optical system is employed, this optical system may be a refraction system, a reflection system, or a cata-dioptric system; furthermore, a reduction system, a magnification system, or an enlargement may be employed.

Furthermore, the present invention is applicable not merely to exposure apparatuses which are used in the manufacture of microdevices such as semiconductor elements, liquid crystal elements (display devices), thin film magnetic heads, or image acquisition elements (CCD), but may also be applied to exposure apparatuses which transfer a circuit pattern onto a glass substrate or a silicon wafer or the like in order to produce a reticle or a mask. Here, a transmission type reticle is commonly employed in exposure apparatuses which employ DUV (distant ultraviolet) light or VUV (vacuum ultraviolet) light or the like, and silica glass, fluorine doped silica glass, quartz, magnesium fluoride, or quartz crystals or the like are employed as the reticle substrate. Furthermore, reflective masks are employed in exposure apparatuses which employ EUV (extreme ultraviolet) light as the exposure energy beam, and transmission type masks (stencil masks, membrane masks) are employed in proximity type X-ray exposure apparatuses or electron beam exposure apparatuses or the like, and silicon wafers are commonly employed as these mask substrates.

Illumination optical systems and projection optical systems comprising a plurality of optical elements are combined with an exposure apparatus main body and optical adjustment is conducted, a reticle stage or wafer stage comprising a plurality of physical parts is attached to the exposure apparatus main body and wires or pipes are connected, and the case 1, exposure optical system (subchamber 6), projection optical system PL, and environment chamber 7, respectively, are connected with the helium circulation apparatus or nitrogen circulation apparatus or the like, and furthermore, by conducting overall adjustment (electrical adjustment, operational adjustment, or the like), it is possible to construct an exposure apparatus of the embodiments described above. It is desirable that the manufacture of the exposure apparatus be conducted in a clean room in which the temperature and degree of cleanliness are controlled.

Furthermore, semiconductor devices are produced via a step in which the qualities and characteristic of the device are designed, a step in which, based on the design step, the reticle is produced, a step in which a wafer is produced from a silicon material, a step in which the pattern of the reticle is exposed onto the wafer by means of an exposure apparatus of the embodiments described above, a step in which the device is assembled (including a dicing procedure, a bonding procedure, and a packaging procedure), and a testing step and the like.

Next, an example of the third embodiment of the present invention will be explained with reference to the figures. This embodiment is one in which the present invention is applied to a step and scan type projection exposure apparatus for the production of semiconductor devices in which helium gas is supplied to the majority of the optical path of the exposure light.

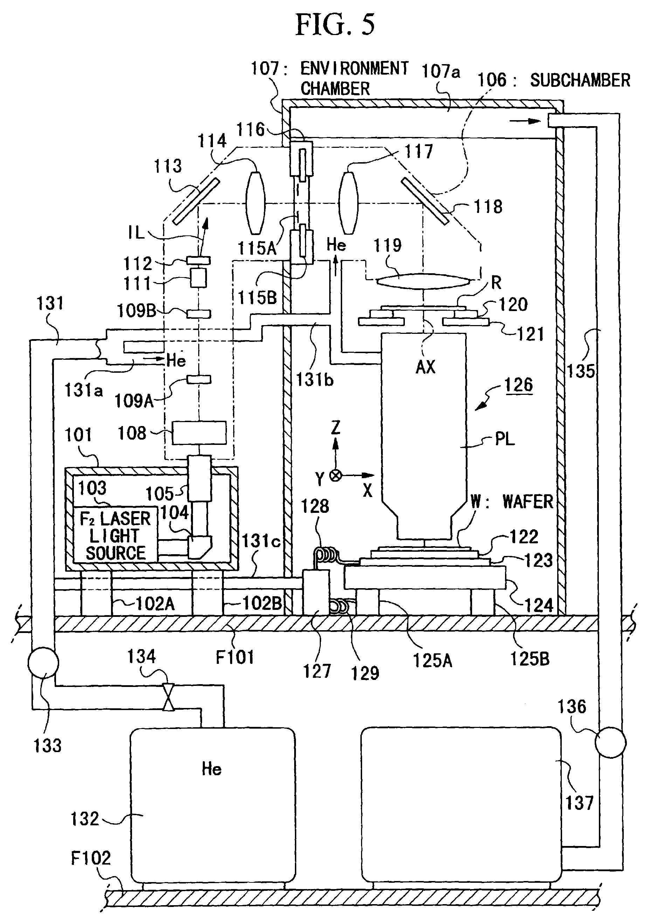

Figure 5 shows the outlines of the structure of the projection exposure apparatus of the present embodiment and the hydrogen supply apparatus; in this Figure 5, the projection exposure apparatus is disposed within a clean room on a floor F101 of a semiconductor manufacturing facility, and a hydrogen supply apparatus for supplying helium gas to the projection exposure apparatus, and a recovery apparatus for recovering a portion of the helium gas, are disposed within an equipment chamber (utility space) on a floor F102 on a lower floor. In this way, the apparatuses which are likely to give rise to particulate matter and to be sources of vibration are disposed on a floor which is different than the floor on which the projection exposure apparatus is installed, and thereby, it is possible to set the interior of the clean room in which the projection exposure apparatus is installed to an extremely high degree of cleanliness, and to reduce the effects of vibration on the projection exposure apparatus.

First, a cylinder 132 which stores compressed helium gas is installed on floor F102, and helium, the temperature of which is controlled and is at a predetermined pressure, is supplied from this cylinder 132 to a pipe 131 which passes through a passage hole provided in floor F101 of the upper level. An electromagnetic type opening and closing valve 134 and blowing fan 133 are installed in pipe 131 at the side of bottom surface of the floor F101, and by means of this, the amount of helium supplied can be controlled,

Next, in the clean room on floor F101, a box shaped case 101 is installed via vibration isolation platforms 102A and 102B, and in this case 101, a F₂ laser light source 103 (with an oscillation wavelength of 157 nm) is installed as a exposure light source, and a beam matching unit (BMU) 104 containing movable mirrors and the like for positionally matching the optical path with the exposure main unit, and a light isolating pipe 105 through the interior of which the exposure light passes, are also installed. KrF or ArF excimer laser light sources or the like may be employed as the exposure light sources. Furthermore, an environment chamber 107 which is box shaped and which has good airtightness is disposed next to case 101, and within environment chamber 107, a fixed platform 124 is installed on floor F101 via vibration isolation platforms 125A and 125B for reducing the vibration from the floor, and exposure main unit 126 is disposed on fixed platform 124. Furthermore, a subchamber 106 having good airtightness is disposed in a framing manner from the pipe 105 which projects from within the case 101 to the interior of environment chamber 107, and the majority of the illumination optical system is contained in the subchamber 106.

In Figure 5, during exposure, an ultraviolet pulse light IL having a wavelength of 157 nm reaches the interior of subchamber 106 via BMU 104 and the interior of pipe 105 as exposure light emitted from the F₂ laser light source 103 within case 101. In subchamber 106, the ultraviolet pulse light IL enters into a fly eye lens 111 via a beam forming optical system comprising, as an optical attenuator, a variable light reducer 108, and lens systems 109A and 109B. An aperture stop system 112 of the illumination system which serves to variously modify the illumination conditions is disposed at the output surface of the fly eye lens 111.

The ultraviolet pulse light IL which is emitted from the fly eye lens 111 and passes through a predetermined aperture diaphragm in the aperture stop system 112 passes a reflection mirror 113 and a condenser lens system 114 and is inputted into a fixed illumination field diaphragm (fixed blind) 115A having a slit shaped opening within a reticle blind mechanism 116. Furthermore, a movable blind 115B which serves to change the width in the scanning direction in the illumination field region is disposed within reticle blind mechanism 116 separately from fixed blind 115A, and by means of this moveable blind 115B, a reduction in the movement stroke in the scanning direction of the reticle stage, and a reduction in the width of the light blocked band of the reticle R, are achieved.

The ultraviolet pulse light IL which is formed in a slit shape by the fixed blind 115A of the reticle blind mechanism 116 passes image forming lens system 117, reflection mirror 118 and main condenser lens system 119, and illuminates at an equal intensity a slit shaped illumination region on the circuit pattern of reticle R. In the present embodiment, the space from the output surface of light-insulating pipe 105 to the main condenser systems 119 is contained within subchamber 106, and furthermore, the space from the inner part of pipe 105 to the output surface of the F₂ laser light source 103 is airtight, and communicates with the space within subchamber 106. Furthermore, helium gas which has a specified purity or greater and is temperature controlled is supplied from two points from the helium circulation apparatus into the space within subchamber 106 via branch pipes 131a and 131b of pipe 131. Helium has a low molecular weight and is susceptible to leaking, so that a portion of the helium which naturally leaks out of subchamber 106 rises and collects in the space 107a in the vicinity of the ceiling of the environment chamber 107.

On the basis of ultraviolet pulse light IL, the circuit pattern within the illumination region of reticle R is illuminated onto the slit shaped exposure region of the resist layer on a wafer W via projection optical system PL. This exposure region is positioned on one shot region within a plurality of shot regions on the wafer. The projection optical system PL in the present embodiment is a dioptric system (refraction system); however, since the glass which is able to transmit ultraviolet light having this type of short wavelength is limited, the projection optical system PL may be made a cata-dioptric system or a reflection system so as to increase the transmittivity of the ultraviolet pulse light IL in the projection optical system PL.

Furthermore, in the same manner as the interior of subchamber 106, temperature controlled helium gas having a predetermined concentration or greater is supplied to the entirety of the space within the barrel of the projection optical system PL of the present embodiment (the space between the plurality of lens elements), from the helium circulation apparatus in the lower floor and via branch pipe 131b of pipe 131. The helium leaking from the barrel of the projection optical system PL rises and collects in the space 107a in the vicinity of the ceiling of the environment chamber 107. In the following, a Z axis is obtained which is parallel to the optical axis AX of the projection optical system PL, and in a plane perpendicular to the Z axis, a X axis will be established which is parallel to the paper surface of Figure 5, and a Y axis will be established which is perpendicular to the paper surface of Figure 1.

At this time, reticle R is supported by vacuum on the reticle stage 120, and reticle stage 120 is made moveable at a constant velocity in the X direction (the scanning direction) on reticle base 121, and is installed so as to be capable of slight movements in the X direction, the Y direction, and the rotational direction. The two dimensional position of reticle stage 120 (reticle R) and the rotational angle thereof are controlled by a drive control unit, which is not depicted in the figure, which is provided with a laser interferometer.

On the other hand, wafer W is supported by vacuum on a wafer holder not depicted in the figure, and the wafer holder is affixed to the sample platform 122, while the sample platform 122 is positioned on the XY stage 123, and the XY stage 123 is placed on fixed platform 124. The wafer stage comprises sample platform 122, the XY stage 123, and guide members not depicted in the figure, and sample platform 122 controls the focus position of wafer W (the position in the Z axis) in an auto focus manner, and controls the angle of inclination, so as to bring the surface of wafer W into agreement with the image plane of the projection optical system PL. Furthermore, XY stage 123 conducts the constant velocity scanning of wafer W in the X direction, and stepping in the X and Y directions. The two dimensional position of XY stage 123 (wafer W) and the rotational angle thereof are controlled by means of a drive control unit which is not depicted in the figure and which is provided with a laser interferometer. During scanning exposure, reticle R is scanned at a velocity of Vr in the + X direction (or in the - X direction) with respect to the illumination area of the ultraviolet pulse light IL, via reticle stage 120, and synchronously therewith, this wafer W is scanned in the - X direction (or in the + X direction) at a speed of β·Vr (where β is the projection magnification from reticle R onto wafer W), with respect to the exposure region and via the XY stage 123.

Furthermore, the XY stage 123 in the wafer stage of the present embodiment is of a type which moves in a non-contacting manner along a guide surface by the static pressure gas bearing method, and the same helium which is supplied to the optical path of the ultraviolet pulse light IL may be employed as the gas of this static pressure gas bearing. Furthermore, the vibration isolation platforms 125A and 125B which support the fixed platform 124 employ the gas spring method, and helium is used as the gas of this gas spring. For this reason, a temporary storage cylinder is disposed within environment chamber 107, and helium is supplied from the hydrogen supply apparatus of the lower floor to the temporary storage cylinder 127 via branch pipe 131c of pipe 131, and helium is supplied to the XY stage 123 from the temporary storage cylinder 127 via a highly flexible pipe 128 (which comprises a plurality of pipes in actuality), and in parallel with this, helium is supplied to vibration isolation platforms 125A and 125B as well via highly flexible pipe 129 (in actuality comprising a plurality of pipes). The static pressure gas bearing mechanism of the XY stage 123 will be discussed hereinbelow.

Furthermore, in the present embodiment, nitrogen gas (N₂), which is temperature controlled, and the amount of oxygen contained in which is suppressed at an extremely low level, is supplied to the interior of the environment chamber 107 from a nitrogen circulation apparatus on the lower floor which is not depicted in the figure. Then, the nitrogen gas circulating in the environment chamber 107 returns from, for example, an exhaust hole (not depicted in the figure) in the lower surface side of the environment chamber 107 to the nitrogen circulation apparatus. In place of the nitrogen gas, helium may be circulated to the entirety of the interior of the environment chamber 107.

Next, within environment chamber 107, the helium which leaks from the subchamber 106 and the helium which leaks from the projection optical system PL and the XY stage 123 and the like is lighter than the air or nitrogen which becomes mixed in from the exterior of the environment chamber 107, so that it rises and collects in the space 107a in vicinity of the ceiling. In the present embodiment, a pipe 135 is connected to this space 107a from the exterior of the environment chamber 107, and the pipe 135 passes through an opening provided in floor F101 and communicates with the helium recovery apparatus in the lower floor. A suction fan 136 is installed in the pipe 135 at the bottom surface side of floor F101, and the gas which is sucked from the space 107a by the pipe 135 and the fan 136 is recovered in recovery cylinder 137 on the floor F102 of the lower floor. A dust collecting and moisture removing apparatus, and a separation apparatus for separating the helium from the other gases, are provided within the cylinder 137, and the separated helium is stored, and where necessary, is supplied to a process for increasing the purity thereof.

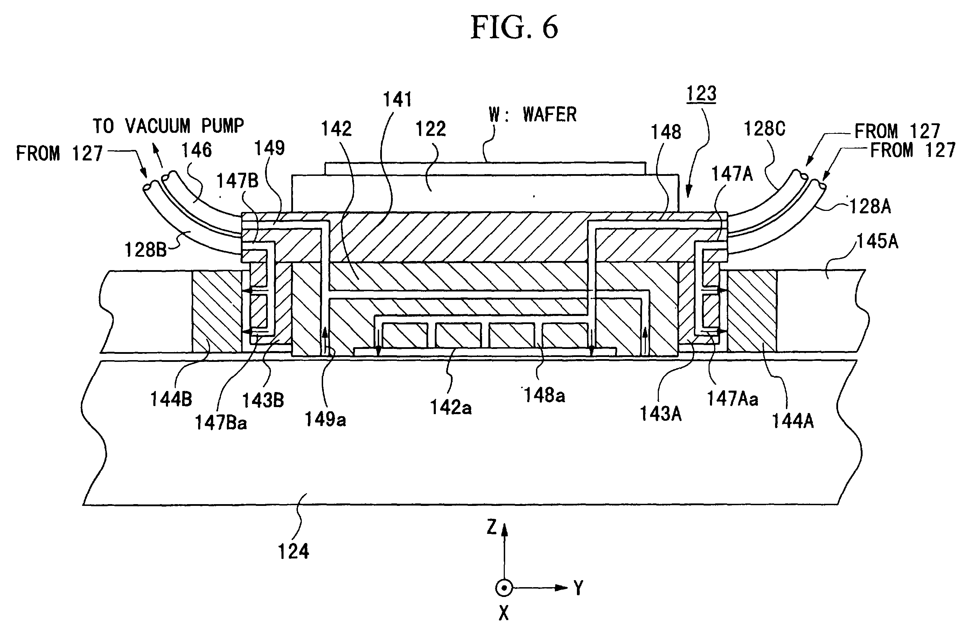

Next, the static pressure gas bearing mechanism of the XY stage 123 on the wafer stage side of the present embodiment will be explained with reference to Figure 6.

Figure 6 shows a cross sectional view of a portion of the wafer stage in Figure 5 viewed from the X direction, and in this Figure 6, wafer W is affixed to the upper plate 141 via a sample platform 122, and a bottom plate 142 is affixed to the bottom surface of the upper plate 141, and bottom plate 142 is placed on the upper surface of fixed platform 124, which upper surface is polished so as to be flat. Furthermore, the bottom plate 142 is affixed to bearing plates 143A and 143B so as to be sandwiched therebetween in the Y direction, and two X guide bars 144A and 144B are installed in a framing manner parallel thereto along the X direction so as to sandwich the bearing plates 143A and 143B in the Y direction. The upper plate 141, lower plate 142, and bearing plates 143A and 143B comprise the XY stage 123, and the XY stage 123 is driven in the X direction along the X guide bars 144A and 144B by a linear motor which is not depicted in the figure. Furthermore, the X guide bars 144A and 144B are unitary, and are driven in the Y direction by a linear motor which is not depicted in the figure along two Y guide bars 145A (a further one is disposed on the front side) which are disposed so as to extend in the Y direction.

Furthermore, a passage hole 147A is formed from upper plate 141 to bearing plate 143A, and helium compressed to a predetermined pressure is supplied from the temporary storage cylinder 127 in Figure 5 to passage hole 147A on the upper plate 141 side via pipe 128A, and this helium is blown out from blow hole 147Aa of bearing plate 143A onto the X guide bar 144A. In the same way, helium compressed to a predetermined pressure is supplied from the temporary storage cylinder 127 in Figure 5 to the passage hole 147B on the upper plate 141 side via pipe 128B, and this helium is blown from blow hole 147Ba within bearing plate 143b onto the X guide bar 144B. By means of this, the bearing plates 143A and 143B are supported in a non-contacting manner while maintaining a predetermined gap with X guide bars 144A and 144B.

Furthermore, a passage hole 148 is formed from upper plate 141 to lower plate 142, and helium which is compressed to a predetermined pressure is supplied from the temporary storage cylinder 127 of Figure 5 to the passage hole 148 on the upper plate 141 side via pipe 128C, and this helium is blown from the blow hole 148a which is provided in the bottom surface of the bottom plate 142 onto the fixed platform 124. A shallow gas pocket part 142a is formed in the region containing the blow hole 148a of the bottom surface of the bottom plate 142, and by means of the pressurized helium which collects in this gas pocket part 142a, the XY stage 123 floats on the upper surface of the fixed plate. Here, an air intake hole 149a is formed in the periphery of the gas pocket part 142a of the bottom surface of the bottom plate 142 so that the XY stage 123 does not float excessively, and the air intake hole 149a communicates with the passage hole 149 which is formed within bottom plate 142 and upper plate 141. The passage hole 149 is connected to a suction pump which is not depicted in the figure via highly flexible pipe 146, and by sucking gas (chiefly helium) from above fixed platform 124 through the air intake hole 149a of the bottom plate 142 using this vacuum pump, the XY stage 123 is stably supported in a non-contacting manner above the fixed platform 124.

In this way, the XY stage 123 of the present embodiment is placed in a non-contacting manner in the Z direction with respect to the fixed platform 124 by the gas bearing method employing helium and is installed in a non-contacting manner in the Y direction with respect to the X guide bars 144A and 144B by the gas bearing method using helium, so that it is possible to move this stage at a high rate of speed using an extremely small amount of force in the X direction and the Y direction on the fixed platform 124.

In this way, in the present embodiment, helium gas which has a transmittivity with respect to light of 150 nm or less, as well, is supplied to the optical path of the ultraviolet pulse light IL from the output surface of the F₂ laser light source 103 of Figure 5 to the main condenser lens system 119, as well as to the optical path of the ultraviolet pulse light IL within the projection optical system PL. Furthermore, the spaces from the main condenser lens system 119 to the input surface of the projection optical system PL, and from the output surface of the projection optical system PL to the surface of the wafer W are supplied with nitrogen gas, which does not have very good transmittivity with respect to light of 150 nm or less; however, the optical path which passes through this nitrogen gas is extremely short, so that there is little absorption as a result of the nitrogen gas. Accordingly, the ultraviolet pulse light IL which is emitted from the F₂ laser light source 103 reaches the surface of wafer W at an overall high transmittivity (efficiency of use), so that it is possible to reduce the exposure period (scanning exposure period) and it is possible to increase the throughput of the exposure process.

Furthermore, in the present embodiment, the gas used for the static pressure gas bearing using the XY stage 123 on the wafer side is helium, and the gas employed in the vibration isolation platforms 125A and 125B is also helium. For this reason, there is no decline in the purity of the helium of the optical path of the ultraviolet pulse light IL as a result of the use of the static pressure air bearings or the like during exposure, and the addition of a gas having a lower transmittivity is prevented in the remainder of the optical path of the ultraviolet pulse light IL, so that the overall transmittivity of the ultraviolet pulse light IL does not decline.

Furthermore, the nitrogen and helium are inert, so that fogging substances are not deposited on the optical members in the optical path of the ultraviolet pulse light IL as a result of chemical reactions.

Furthermore, helium has a thermal conductivity which is approximately six times that of nitrogen, so that the heat energy which is built up as a result of the application of the ultraviolet pulse light IL at the optical elements within the illumination optical system and the optical elements within the projection optical system PL is efficiently transmitted to, respectively, the cover of the subchamber 106, and the barrel of the projection optical system PL via the helium gas. Furthermore, the heat energy of the cover of the subchamber 106, and the barrel of the projection optical system PL, is efficiently exhausted to the exterior, such as lower floors, or the like, by temperature controlled air within the clean room or by temperature controlled nitrogen gas within the environment chamber 107. Accordingly, the rise in temperature of the optical elements of the illumination optical system and the projection optical system PL can be maintained at a very low level, and it is possible to control degradation and image formation characteristics at a minimum level. Furthermore, the amount of change in the index of refraction of helium in response to changes in air pressure is very small, so that the amount of change in the index of refraction within, for example, the projection optical system PL is extremely small and for this reason, as well, it is possible to maintain stable image formation characteristics.

Among the machinery employed in the projection exposure apparatus, that which employs gas includes, for example, gas type cylinder apparatuses employed in the conveyance of the reticle holder system or the wafer holder system. The cylinder apparatuses are provided with a plurality of pistons, and by extending and retracting these pistons using gas, predetermined parts may be moved. It is desirable that helium be used as the gas in these cylinder apparatuses. By means of this, the transmittivity of the ultraviolet pulse light IL can be further improved.

In the embodiment described above, a F₂ laser light was employed as the exposure energy beam; however, even in cases when a ArF excimer laser light (with a wavelength of 193 nm) or KrF excimer laser light (with a wavelength of 248 nm) or X-rays or the Like are employed as the exposure energy beam, when an inert gas such as helium or nitrogen is supplied to at least a portion of the optical path of the exposure energy beam as a gas having good transmittivity, the present application may be applied. In particular, when exposure light having a wavelength within a range of 250 nm - 200 nm, such as KrF excimer laser light, is employed, inexpensive nitrogen can be employed as the gas having good transmittivity. When nitrogen is employed in this way, it is desirable that the gas used in the static pressure air bearing of the XY stage 123 in Figure 6 and as the gas in the vibration isolation platforms 125A and 125B in Figure 5 be nitrogen.

On the other hand, in a projection exposure apparatus which employs ArF excimer laser light having a wavelength of 193 nm as the exposure light, when the projection optical system comprises a cata-dioptric optical system, it is desirable that helium, which has little change in the refractive index, be employed as the gas used to purge the optical system. In this case, the illumination optical system may be purged with either nitrogen or helium; however, it is desirable that the same gas be employed as in the projection optical system, that is to say, helium. Furthermore, when ArF excimer laser light is employed and a projection optical system is employed which comprises a refraction optical system, nitrogen may be employed as the gas used to purge the interior of the projection optical system; however, the use of helium is desirable.

Furthermore, in the present embodiment, an inert gas (helium or nitrogen or the like) which was identical to that used for purging which was supplied to the illumination optical system and projection optical system PL was employed as the gas used in the static pressure gas bearing mechanism (Figure 6), the air cylinder apparatuses, and the like in the present embodiment; however, when, for example, helium is supplied to the projection optical system PL and the like and nitrogen is supplied to the environment chamber 107, the space between the illumination optical system and the projection optical system PL, and the space between the projection optical system PL and the wafer W have nitrogen atmospheres, so that nitrogen may employed in the static pressure gas bearing mechanism described above and the like. At this time, a gas consisting of a mixture of nitrogen and helium at predetermined proportions may also be used in the static pressure gas bearing mechanism and the like.

Furthermore, the first gas which is employed in the static pressure gas bearing mechanism and the like described above, and a second gas for purging which is supplied to the illumination optical system and the projection optical system PL (an inert gas such as nitrogen, helium, or the like), or a second gas which is supplied to the environment chamber 7 (an inert gas for chemically clean dry air or the like) need not have completely identical compositions, or alternatively, if the compositions are the same, the purity (concentration) thereof need not be identical. For example, a mixed gas containing two or more gases (inert gases) containing the second gas, or a gas which is the same as the second gas but has a lower purity than the second gas may be employed as the first gas.

Furthermore, if the gas (inert gas) is capable of reducing attenuation in exposure light, then this gas may be used as the first gas even if it differs from the second gas. That is to say, if the gas is such as to have the same or similar optical characteristics (transmittivity or the like) as the second gas, even if it differs from the second gas, it may be employed as the first gas. For example, when helium is used as the second gas in an exposure apparatus which employs exposure light in the vacuum ultraviolet band having a wavelength of 200 nm or less, at least one type of inert gas (nitrogen or the like) other than helium may be employed as the first gas. Furthermore, when nitrogen is employed as the second gas in an exposure apparatus which uses exposure light having, for example, a wavelength of 190 nm or more, at least one type of inert gas other than nitrogen, or chemically clean dry air (desiccated air) may be employed as the first gas. Here, what is meant by chemically clean is a state in which impurities including the silicon system organic materials and the like described above have been removed.

Furthermore, the exposure main unit 126 of the present embodiment is a step and scan type; however, it is of course the case that the present invention may applied even when a stepping exposure type or a proximity type or the like is employed.

In the embodiment described above, helium gas was supplied to the optical path of the ultraviolet pulse light IL from the output surface of the F₂ laser light source 103 to the main condenser lens system 119, and to the optical path of the ultraviolet pulse light IL within the projection optical system PL, and nitrogen was supplied from the main condenser lens system 119 to the input surface of the projection optical system PL, and from the output surface of the projection optical system PL to the surface of the wafer W; however, it is also possible to apply the helium circulation apparatus and nitrogen circulation apparatus shown in the first and second embodiments to this embodiment. Furthermore, the modifications described in the first and second embodiments may applied in an unchanged fashion.

In the first through third embodiments described above, a fly eye lens was used as an optical integrator (homogenizer); however, in place of the fly eye lens, a rod integrator may be employed, or alternatively, a fly eye lens and a rod integrator may be employed in a combined manner.

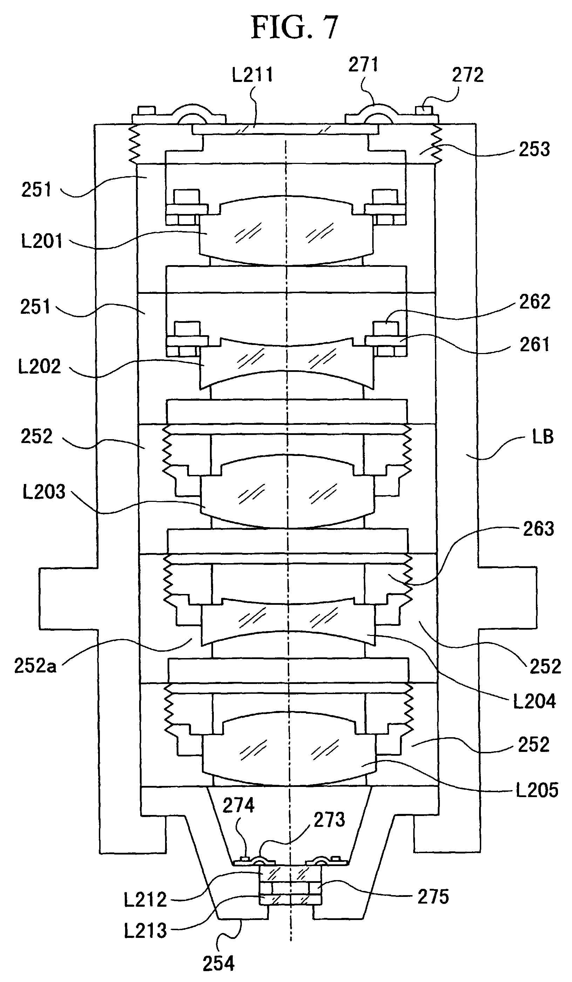

Figure 7 is a diagram showing an example of a preferred support structure for the optical elements of the projection optical system PL in the first embodiment of Figure 1, the second embodiment shown in Figure 4, and the third embodiment shown in Figure 5.

Five refraction type lenses L201 -L205 are supported within a cylindrical barrel LB via lens support tubes 251 and 252, and a parallel flat plate L211 which corrects distortion, particularly the non-rotationally symmetric component, is supported via a lens support tube 253 at the reticle side end of barrel LB, and parallel flat plate L212, which compensates for the spherical aberration, as well as a parallel flat plate L213, which compensates for the eccentric top aberration, are supported at the wafer side end of the barrel LB via lens support member 254.

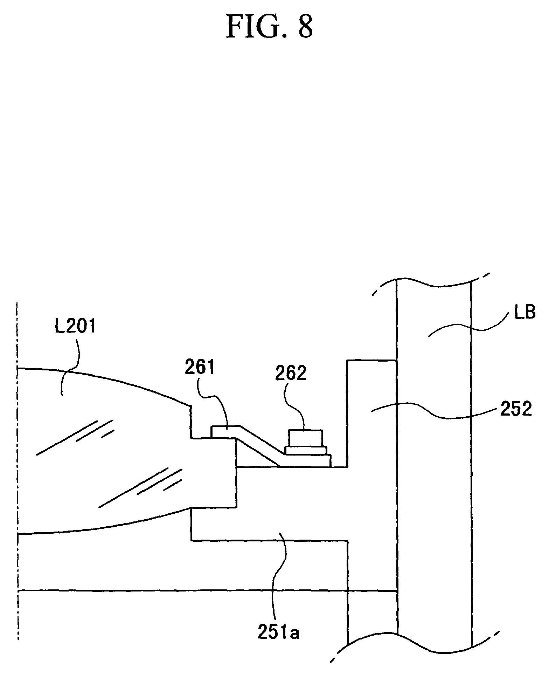

Lenses L201 and L202 are pressure supported in support tube 251 by flat spring 261. As shown in detail in Figure 8, one end of flat spring 261 is screwably attached to the projecting end 251a of lens support tube 251 with a bolt 262, while the other end presses against the pressure flat face of the outer circumferencial part of lens L201, and by means of this, lens L201 is held from both sides by pressure against projecting part 251a. Lens L202 is affixed in lens barrel LB in the same manner. Both leases L201 and L202 are supported in lens barrel LB via support tube 251 without the use of any adhesive (or filler).

As shown in Figure 7, lenses L203- L205 are held by pressure in support tube 252 by screw ring 263. A female thread is provided in the inner wall of support tube 252, and screw ring 263 is screwably attached thereto. When screw ring 263 is screwably advanced and the end surface thereof presses against the pressure flat part of the outer circumferencial part of lenses L203 - L205, lenses L203 -L205 are supported from both sides by pressure against the projecting part 252a of the support tube 252. Lenses L203 - L205 are supported in lens barrel LB via support tube 252 without the use of any adhesive (or filler) at all.

As shown in Figure 7, parallel flat plate L211 is press-supported on support tube 253 by flat springs 271. Support tube 253 is screwably attached to barrel LB. One end of flat spring 271 is screwably attached to support tube 253 by bolts 272, while the other end presses against the outer circumferencial part of the flat plate L211, and by means of this, the flat plate L211 is supported from both sides by pressure against the support tube 253. Flat plate L211, as well, is supported in lens barrel LB via support tube 253 without the use of any adhesive (or filler) at all.

As shown in Figure 7, parallel flat plate L212 is supported in support tube 254 by flat spring 273. One end of flat spring 273 is screwably attached to support tube 254 by bolt 274, while the other end thereof presses against the outer circumferencial part of the parallel flat plate L212, and by means of this, parallel flat plate L212 is supported from both sides by compression against support tube 254. Support tube 254 is supported between the support tube 252 and the barrel LB. Parallel flat plate L213 is affixed to the support tube 254 so as to bracket the spacer ring 275 between it and parallel flat plate L211. Parallel flat plates L212 and L213, as well, are supported in barrel LB via support tube 254 without the use of any adhesive (or filler) at all.

It is possible to use ring shaped flat springs as the flat springs 261, 271, and 273; however, a plurality of belt shaped flat springs may also be disposed at predetermined angles. Furthermore, in the foregoing, the optical elements were attached and supported by the support tubes using flat springs or screw rings; however, the optical elements may be supported by elements of other forms.

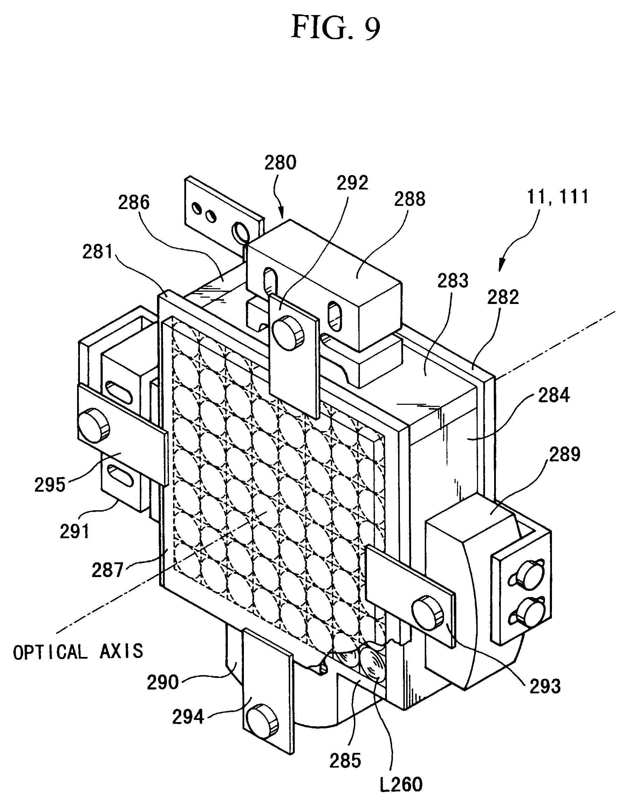

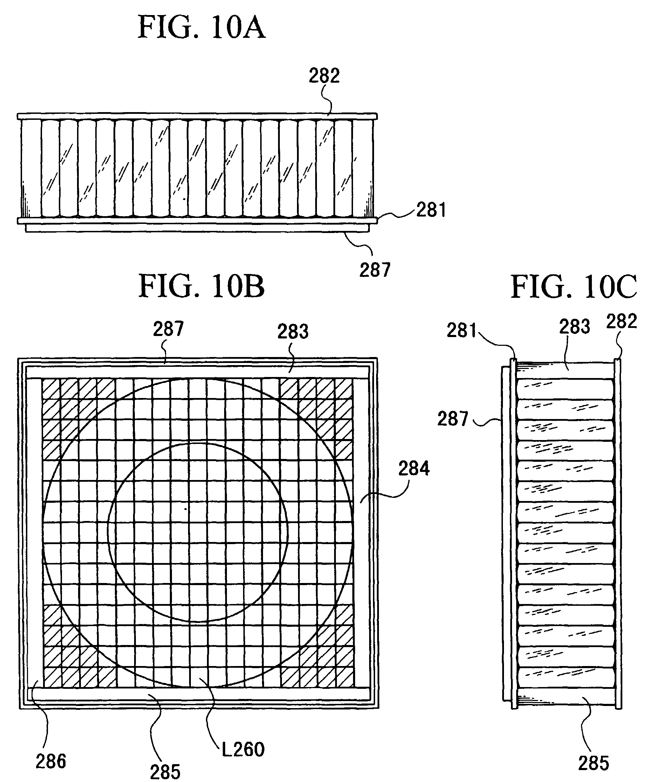

Next, the fly eye lenses 11, and 111 will be explained in detail with reference to Figures 9 and 10.

As shown in Figures 9 and 10, fly eye lenses 11 and 111 are produced by bundling a plurality of rod lenses L260 having the shape of square columns in a support mechanism 280 wherein they are arranged in the form of a matrix, as shown in Figure 10B. Support apparatus 280 is provided with frames 281 and 282 which have the shape of rectangular rings and on the inside of which are collected and contain the rod lenses L260; pressing plates 283 - 286, which press the rod lenses L260 collected in frames 281 and 282 from the four side surfaces; a silica plate 287, which arranges the position in the direction of the optical axis of the rod lenses L260 and which is disposed at one end surface of the rod lenses L260; pressing blocks 288 - 291, which serve to press the rod lenses L260 from one side via pressing plates 283 - 286; and pressing plates 292 - 295, one end of which is affixed to the pressing blocks 288 - 291 and the other end of which presses silica plate 287. The pressing blocks 288 - 291 are attached to affixing fixtures which are not depicted in the figure. In this way, the rod lenses L260 are collected and supported without the use of any adhesive (or filler) at all. In Figure 10B the regions other than the regions indicated by slanting lines are those regions which may be effectively employed as the fly eye lens.

In this way, the optical elements such as lenses, reflecting mirrors, and the like are supported by support members such as support tubes or the like using flat springs or screw rings without the use of adhesives. Accordingly, the volatilization of the organic solvents of adhesives as a result of the application of the ArF excimer laser is eliminated, and contamination of the surfaces of the optical elements by organic materials is prevented. As a result, a decline in the transmittivity of the optical system is prevented. Furthermore, a phenomenon is known in which the contaminant substances which are deposited on the surfaces of the optical elements are stripped from the surfaces of the optical elements by the effects of the light washing of the excimer laser, and as the exposure time passes, the transmittivity rises, and when the illumination of the excimer laser is halted, these are redeposited and the transmittivity decreases; however, by means of supporting the optical elements on support members without the use of adhesive, the generation of the contaminant materials themselves is suppressed, and it is possible to control fluctuations in the transmittivity of the optical system.

In the correspondence between the example of the projection optical system explained above and the elements in the claims, the various lenses 9A (109A), 9B (109B), 11 (111), 13 (113), L201, and L202... form the optical elements, support tubes 251, 252, 253, and 254 and the like form the support members, and flat springs 261, 271, and 273 and pressure ring 263 form the press-attachment mechanism.

### INDUSTRIAL APPLICABILITY

In accordance with the exposure apparatus and the device manufacturing apparatus of the present invention, at least a portion of the gas having high transmittivity with respect to the exposure energy beam (exposure light) and which has good heat transmittivity is recovered, so that the efficiency of use of the exposure energy beam is increased, and the cooling efficiency of the optical elements and the like of the exposure apparatus is increased, and this has an advantage in that the amount of gas employed can be reduced. In other words, this gas can be recycled to a certain extent, and the operating costs of the exposure apparatus can be reduced.

Furthermore, when this gas is helium, because helium is stable and has a high transmittivity and high thermal conductivity, the efficiency of use of the exposure energy beam is particularly increased, and the cooling effects are increased. On the other hand, helium has low availability and is high in cost, so that the effect of reduction of the operating costs by means of the present invention is particularly large.

Furthermore, when the gas recovery apparatus is commonly employed by a plurality of exposure apparatuses, the recovery costs can be further decreased.

Furthermore, in the case in which the gas recovered by the gas recovery apparatus is recirculated to the optical path of the exposure energy beam via at least one gas supply apparatus, it is possible to reduce the amount of gas for replenishment.

Furthermore, when the gas supply apparatus is provided with a concentration meter for measuring the concentration of the gas supplied from the gas recovery apparatus, a gas source which is filled with this gas, and a control unit which replenishes the gas supplied from the gas recovery unit with gas from the gas source in accordance with the results of the measurement of the concentration meter, this has the advantage that gas can always be supplied to the optical path of the exposure energy beam at a predetermined purity (concentration) or above. Furthermore, when the gas is compressed at high pressures or is liquefied and stored, it is possible to store a large amount of this gas in a small space.

Furthermore, in accordance with the exposure apparatus of the present invention, a gas (a second gas) having a predetermined high transmittivity is supplied to at least a portion of the optical path of the exposure energy beam (exposure light), and in this case, the gas of the gas controlled drive apparatus is the same type as the second gas having high transmittivity. Accordingly, the concentration of the second gas does not decrease, so that the exposure energy beam can be guided to the substrate with high efficiency, and this has an advantage in that it is possible to increase the throughput of the exposure process.

Furthermore, when the gas controlled drive apparatus is a stage apparatus which makes contact with the guide surface using a gas bearing method, this stage is disposed at a position close to the mask or the substrate, so that the transmittivity of the exposure energy beam is maintained at a high level.

Furthermore, when the exposure energy beam is ultraviolet light having a wavelength of 250 nm or less and nitrogen or helium is employed as this second gas, nitrogen has a low cost, while helium has high transmittivity and good thermal conductivity.

Furthermore, when the exposure energy beam is a X-ray, when nitrogen or helium is employed as the second gas, a certain amount of transmittivity can be obtained if the distance over which the X-ray must pass through the gas short.

Furthermore, in accordance with exposure apparatus of the present invention, all of the optical elements of the illumination optical system and the projection optical system are supported on support elements using press-attachment mechanisms without the use of adhesive, so that the volatilization of the organic solvents of the adhesives by the application of the ultraviolet light, and the contamination of the surfaces of the optical elements are prevented, and it is possible to control declines or fluctuations in the transmittivity. Furthermore, the fly eye lens which is formed from a plurality of rod lenses is put together without the use of adhesive, so that the volatilization of the organic solvents of the adhesives by the application of ultraviolet light and the contamination of the surfaces of the optical elements is prevented, and it is possible to prevent declines or fluctuations in the transmittivity.

## Claims

1. An exposure apparatus having an illumination system which applies an exposure energy beam to a mask having a pattern, and a stage system for positioning a substrate to which said pattern of said mask is transferred, characterized in that:
a gas supply apparatus for supplying a gas of a high transmittivity with respect to said exposure energy beam, and having good thermal conductivity, to at least a portion of an optical path of said exposure energy beam, and
a gas recovery apparatus for recovering at least a portion of said gas after said gas is supplied to the optical path of said exposure energy beam from said gas supply apparatus,
are provided.

2. An exposure apparatus in accordance with claim 1, wherein said gas is helium.

3. An exposure apparatus in accordance with claim 1, wherein said gas supply apparatus is commonly employed by a plurality of exposure apparatuses.

4. An exposure apparatus in accordance with claim 1, wherein said gas recovered by said gas recovery apparatus is recirculated to the optical path of said exposure energy beam via at least a portion of said gas supply apparatus.

5. An exposure apparatus in accordance with claim 4, wherein said gas supply apparatus comprises:
a concentration meter for measuring the concentration of said gas supplied from said gas recovery apparatus,
a gas source filled with said gas in a gaseous state or a liquefied state, and
a control unit for replenishing gas supplied from said gas recovery apparatus with gas from said gas source in accordance with measurement results of said concentration meter.

6. An exposure apparatus in accordance with claim 1, wherein said gas supply apparatus comprises:
a gas source for conducting liquefied storage or high-pressure storage of said gas,
a conversion apparatus for returning the liquefied gas or high-pressure gas within said gas source to said gas, and
an adjusting apparatus for adjusting temperature and pressure of said gas prior to supplying said gas from said gas source to said exposure apparatus.

7. An exposure apparatus in accordance with claim 1, wherein said gas recovery apparatus liquefies said recovered gas or highly pressurizes it and stores it.

8. An apparatus for manufacturing devices characterized in having a plurality of exposure apparatuses including the exposure apparatus of claim 1, and in overlaying and transferring a plurality of device patterns onto a substrate which is exposed and manufacturing microdevices.

9. An exposure apparatus which illuminates a mask with a predetermined exposure energy beam and transfers a pattern formed in said mask onto a substrate, characterized in that:
a gas-controlled drive apparatus is provided which conducts predetermined operations using a first gas for control,
a second gas having good transmittivity is supplied to at least a portion of the optical path of said exposure energy beam, and
a gas of the same type as said second gas is employed as said first gas for said gas-controlled drive apparatus.

10. An exposure apparatus in accordance with claim 9, wherein said gas-controlled drive apparatus comprises a stage apparatus which makes contact with guide surfaces by the gas bearing method, a gas-type cylinder apparatus, or a vibration isolation platform using gas as a portion of the shock absorbing material.

11. An exposure apparatus in accordance with claim 9, wherein, when said exposure energy beam is ultraviolet light having a wavelength of 250 nm or less, nitrogen or helium is used as said second gas.

12. An exposure apparatus in accordance with claim 9, wherein, when said exposure energy beam is ultraviolet light having a wavelength of 200 nm or less, helium is used as said second gas.

13. An exposure apparatus in accordance with claim 9, wherein, when said exposure energy beam is an X ray, nitrogen or helium is used as said second gas.

14. An exposure apparatus comprising:
an illumination optical system, having a plurality of optical elements supported by supporting members, which applies illumination light from an illumination light source to a mask having a pattern, and
a projection optical system, having a plurality of optical elements supported by supporting members, which projects an image of a pattern on said mask onto a photosensitive substrate, characterized in that:
all said optical elements are supported by said supporting members using push-attachment mechanisms without the use of adhesive.

15. An exposure apparatus in accordance with claim 14, wherein said push-attachment mechanisms comprise flat springs having one end thereof affixed to an inner circumferential part of said support members, and at another end, press against an outer circumferential part of said optical elements.

16. An exposure apparatus in accordance with claim 14, wherein said push-attachment mechanisms comprise screw rings which screwably attach to a screw part provided in an inner circumferential part of said support members and which are screwably advanced and press against an outer circumferential part of said optical elements.

17. An exposure apparatus comprising:
an illumination optical system, having a plurality of optical elements including a fly-eye lens bundling a plurality of rod lenses, which applies illumination light from an illumination light source to a mask, and
a projection optical system, having a plurality of optical elements supported by supporting members, which projects an image of a pattern on said mask onto a photosensitive substrate, characterized in that:
said plurality of rod lenses are bundled by a support apparatus without the use of adhesive.

18. A manufacturing method for apparatuses wherein an exposure energy beam is applied to a mask and a substrate is exposed by said exposure energy beam via said mask, comprising:
a supply pipe for supplying a gas for reducing attenuation of said exposure energy beam is connected to a gas chamber which seals, in an essentially airtight manner, at least a portion of the optical path of said exposure energy beam; and
a recovery pipe for recovering at least a portion of the gas supplied to said gas chamber is connected to at least one of said gas chamber and a housing in which said gas chamber is disposed.

19. A manufacturing method for exposure apparatuses in accordance with claim 18, comprising said recovery pipe is connected to a removal apparatus for removing impurities from recovered gas, and said removal apparatus and said supply pipe are connected.

20. A manufacturing method for exposure apparatuses in accordance with claim 18 further comprising optical elements which said exposure energy beam passes are affixed to supporting members without using adhesive, and are assembled into said exposure apparatus.

21. A manufacturing method for exposure apparatuses in accordance with claim 18 further comprising a gas-controlled drive apparatus which is provided in said exposure apparatus and which employs a gas having optical characteristics which are essentially identical to those of said gas is connected with said gas supply source.
